(19) Europäisches Patentamt
European Patent Office
Office européen des brevets

(11) **EP 2 023 489 B1**

(12) **EUROPEAN PATENT SPECIFICATION**

(45) Date of publication and mention
of the grant of the patent:
**09.02.2011 Bulletin 2011/06**

(51) Int Cl.:
**H03M 1/08** (2006.01)　　　　**H03K 17/041** (2006.01)

(21) Application number: **07113381.3**

(22) Date of filing: **27.07.2007**

(54) **Current switching circuitry**

Stromschaltungsanordnung

Circuit de commutation de courant

(84) Designated Contracting States:
**DE FR GB**

(43) Date of publication of application:
**11.02.2009 Bulletin 2009/07**

(60) Divisional application:
**10164671.9 / 2 237 425**

(73) Proprietor: **Fujitsu Semiconductor Limited
Kohoku-ku, Yokohama-shi
Kanagawa 222-0033 (JP)**

(72) Inventors:
• **Dedic, Ian Juso
Northolt, Middlesex UB5 5HW (GB)**
• **Walker, Darren
Caversham, Reading, Berkshire RG4 5EA (GB)**

(74) Representative: **Wilding, Frances Ward
Haseltine Lake LLP
Lincoln House, 5th Floor
300 High Holborn
London WC1V 7JH (GB)**

(56) References cited:
**US-A1- 2002 030 619　　US-A1- 2002 030 621
US-B1- 7 129 871**

**Description**

The present invention relates to current switching circuitry for use, for example, in high-speed digital-to-analogue converters (DACs).

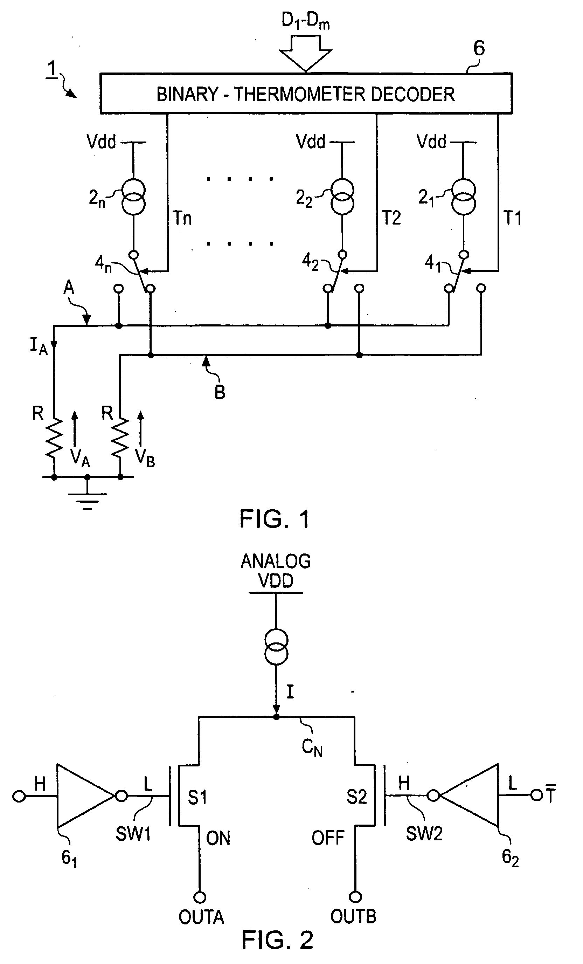

Figure 1 of the accompanying drawings shows parts of a conventional digital-to-analogue converter (DAC) of the so-called "current-steering" type. The DAC 1 is designed to convert an m-bit digital input word (D1-Dm) into a corresponding analogue output signal.

The DAC 1 includes a plurality (n) of identical current sources $2_1$ to $2_n$, where $n=2^m-1$. Each current source 2 passes a substantially constant current I. The DAC 1 further includes a plurality of differential switching circuits $4_1$ to $4_n$ corresponding respectively to the n current sources $2_1$ to $2_n$. Each differential switching circuit 4 is connected to its corresponding current source 2 and switches the current I produced by the current source either to a first terminal, connected to a first connection line A of the converter, or a second terminal connected to a second connection line B of the converter.

Each differential switching circuit 4 receives one of a plurality of control signals T1 to Tn (called "thermometer-coded signals" for reasons explained hereinafter) and selects either its first terminal or its second terminal in accordance with the value of the signal concerned. A first output current $I_A$ of the DAC 1 is the sum of the respective currents delivered to the differential-switching-circuit first terminals, and a second output current $I_B$ of the DAC 1 is the sum of the respective currents delivered to the differential-switching-circuit second terminals.

The analogue output signal is the voltage difference $V_A$-$V_B$ between a voltage $V_A$ produced by sinking the first output current $I_A$ of the DAC 1 into a resistance R and a voltage $V_B$ produced by sinking the second output current $I_B$ of the converter into another resistance R.

In the Figure 1 DAC the thermometer-coded signals T1 to Tn are derived from the binary input word D1-Dm by a binary-thermometer decoder 6. The decoder 6 operates as follows.

When the binary input word D1-Dm has the lowest value the thermometer-coded signals T1-Tn are such that each of the differential switching circuits $4_1$ to $4_n$ selects its second terminal so that all of the current sources $2_1$ to $2_n$ are connected to the second connection line B. In this state, $V_A = 0$ and $V_B = nIR$. The analogue output signal $V_a$-$V_B$ = -nIR.

As the binary input word D1-Dm increases progressively in value, the thermometer-coded signals T1 to Tn produced by the decoder 6 are such that more of the differential switching circuits select their respective first terminals (starting from the differential switching circuit $4_1$) without any differential switching circuit that has already selected its first terminal switching back to its second terminal. When the binary input word D1-Dm has the value i, the first i differential switching circuits $4_1$ to $4_i$ select their respective first terminals, whereas the remaining n-i differential switching circuts $4_{i+1}$ to $4_n$ select their respective second terminals. the analogue output signal $V_A$-$V_B$ is equal to (2i-n) IR.

Thermometer coding is popular in DACs of the current-steering type because, as the binary input word increases, more current sources are switched to the first connection line A without any current source that is already switched to that line A being switched to the other line B. Accordingly, the input/output characteristic of the DAC is monotonic and the glitch impulse resulting from a change of 1 in the input word is small.

Figure 2 shows a previously-considered form of differential switching circuit suitable for use in a digital-to-analogue-converter such as the Figure 1 converter.

This differential switching circuit 4 comprises first and second PMOS field effect transistors (FETs) S1 and S2. The respective sources of the transistors S1 and S2 are connected to a common node CN to which a corresponding current source ($2_1$ to $2_n$ in Figure 1) is connected. The respective drains of the transistors S1 and S2 are connected to respective first and second output nodes OUTA and OUTB of the circuit which correspond respectively to the first and second terminals of each of the Figure 1 differential switching circuits.

Each transistor S1 and S2 has a corresponding driver circuit $6_1$ or $6_2$ connected to its gate. A corresponding one of the thermometer-coded signals T is applied to the input of the driver circuit $6_1$, whilst a signal T complementary to the signal T is applied to the input of the driver circuit $6_2$. Each driver circuit buffers and inverts its received input signal T or T to produce a switching signal SW1 or SW2 for its associated transistor S1 or S2 such that, in the steady-state condition, one of the transistors S1 and S2 is on and the other is off. For example, as indicated in Figure 2 itself, when the input signal T has the high level (H) and the input signal T has the low level (L), the switching signal SW1 (gate drive voltage) for the transistor S1 is at the low level L, causing that transistor to be ON, whereas the switching signal SW2 (gate drive voltage) for the transistor S2 is at the high level H, causing that transistor to be OFF. Thus, in this condition, all of the input current flowing into the common node CN is passed to the output node OUTA and no current passes to the output node OUTB.

Referring back to Fig. 1, in the Fig. 1 DAC the voltages $V_A$ and $V_B$ of the first and second connection lines A and B of the DAC vary in use of the DAC according to the value of the binary input word D1-Dm. This means that the potentials of the output nodes OUTA and OUTB of the differential switching circuit 4 also vary in use of the DAC. The transistors S1 and S2 have an appreciable parasitic capacitance. These parasitic capacitances must be charged or discharged whenever the differential switching circuit is switched over. The amount of charge that is charged or discharged is then dependent upon the change in the output voltages $V_A$ and $V_B$ of the DAC from one code to the next, resulting in a switching delay at the DAC output that is dependent upon the DAC output voltage. If, for example, the DAC is used to synthesise a sinewave at a selected frequency (for example 100MHz) the output-voltage-dependent delay manifests itself as pulse width modulation at the DAC output. In a high-speed precision DAC this degrades the first-order performance of the DAC significantly. Furthermore, another problem is that the output conductances of the transistors S1 and S2 at the instant of switch-over depend weakly on the actual output voltages $V_A$ and $V_B$ of the DAC. This also degrades the DAC performance in high-precision applications.

To address these problems, the present applicant has proposed in GB-A-2356302 various arrangements for shielding the differential switching circuitry in each segment from the effects of variations in the potentials of the output nodes OUTA and OUTB. Some of these arrangements will be described in more detail later in the present specification. However, the effectiveness of the shielding arrangements concerned is limited because they do not address all of the causes of variation in the potentials of the terminals of the main switching transistors (S1 and S2 in Figure 2) in operation of the circuitry.

US-A1-2002/0030619 discloses that the performance of a single-bit cell in a DAC can be improved by decoupling the voltage swing across the load resistors from the output of the current steering device. This can be achieved by providing for a single-bit cell having a first load resistor R1 and a second load resistor, R2, a current steering circuit, and a decoupling circuit operably coupled between the current steering circuit and the resistors R1, R2. The current steering circuit steers at least part of a current 11 through a circuit path towards either the first resistor R1 or the second resistor R2. The decoupling circuit decouples voltage swings across the load resistors R1, R2 from the current steering circuit.

Aspects of the present invention are defined in the independent claims, to which reference should now be made. Particular embodiments are set out in the dependent claims.

It is envisaged that the present invention may extend to further such aspects. According to an embodiment of a further aspect of the present invention there is provided a digital-to-analogue converter (DAC) comprising circuitry according to any of the above-mentioned aspects of the present invention. Such a DAC may operate at a sample rate of around 12GSa/s. Circuitry embodying the present invention may be provided in the form of an integrated circuit (IC) chip or chipset. According to an embodiment of a further aspect of the present invention there is provided an IC chip or chipset comprising circuitry according to any of the above-mentioned aspects of the present invention. Such an IC chip or chipset may be a small-geometry CMOS IC chip or chipset. Circuitry embodying the present invention may form part of an RF transmitter, for example part of a DAC of an RF transmitter. According to an embodiment of a further aspect of the present invention there is provided an RF transmitter comprising circuitry or an IC chip or chipset (as the case may be) according to any of the above-mentioned aspects of the present invention.

Reference will now be made, by way of example, to the accompanying drawings, in which:

Figure 1, discussed hereinbefore, shows parts of a previously-considered DAC;
Figure 2, also discussed hereinbefore, shows parts of current switching circuitry previously considered for use in the Figure 1 DAC;
Figure 3 shows current switching circuitry having a first previously-considered shielding arrangement;
Figure 4 shows waveforms generated in the Figure 3 circuitry;
Figure 5 shows current switching circuitry having a second previously-considered shielding arrangement;
Figure 6 shows current switching circuitry embodying the present invention;
Figure 7 shows one of the parts of the Figure 6 circuitry;
Figure 8 shows current switching circuitry according to a first embodiment to the present invention;
Figure 9 presents simulation results relating to an AC performance of the Figure 8 circuitry;
Figure 10 shows simulation results relating to a DC performance of the Figure 8 circuitry;
Figure 11 shows a first alternative implementation of one of the parts of the Figure 6 circuitry;
Figure 12 shows a second alternative implementation of the part of Figure 11;
Figure 13 shows an alternative implementation of another of the parts of the Figure 6 circuitry;
Figure 14 shows parts of current switching circuitry according to an arrangement not directly embodying the present invention;
Figure 15 shows parts of current switching circuitry according to a second embodiment of the present invention; and
Figure 16 is a schematic diagram 160 representing circuitry for addressing design considerations regarding the Figure 8 circuitry.

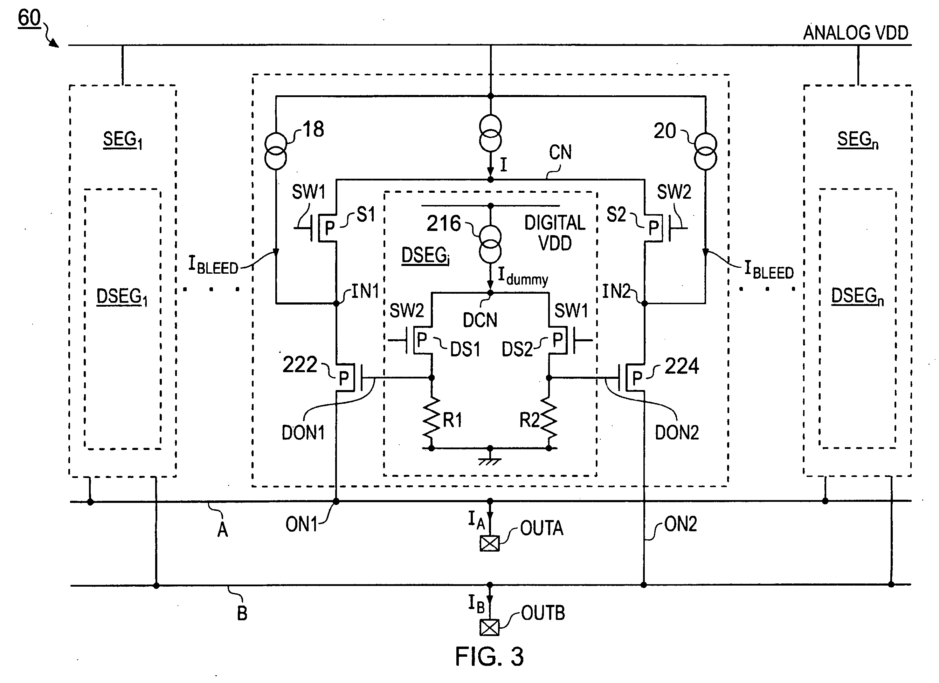

Before describing embodiments of the invention, previously-considered shielding arrangements will be described with reference to Figures 3 to 5.

In Fig. 3, current switching circuitry 60 has, in each segment, a pair of main switching transistors S1 and S2 connected for receiving mutually-complementary switching signals SW1 and SW2 as in Figure 2. The first switching transistor S1 is connected between the segment's common node CN and a first intermediate node IN1 of the segment.

Similarly, the second switching transistor S2 is connected between the segment's common node CN and a second intermediate node IN2 of the segment.

Each segment also has its own individual pair of cascode transistors 222 and 224. The first cascode transistor 222 has its source connected to the first intermediate node IN1, its drain connected to a first output node ON1 of the segment and its gate connected to a first dummy DAC output node DON1. The second cascode transistor 224 has its source connected to the intermediate node IN2, its drain connected to a second output node ON2 of the segment and its gate connected to a second dummy DAC output node DON2.

All of the respective output nodes ON1 of the segments are connected in common to a first connection line A of the circuitry, to which a first output terminal OUTA of the circuitry is connected. Similarly, all of the respective output nodes ON2 of the segments are connected in common to a second connection line B of the circuitry, to which a second output terminal OUTB of the circuitry is connected. Respective current bleed circuits 18 and 20 are connected respectively to the first and second intermediate nodes IN1 and IN2 in each segment.

For each segment SEG (hereinafter "main segment") in the Fig. 3 circuitry there is also provided a corresponding segment DSEG of a dummy DAC used to provide the gate potentials of the cascode transistors 222 and 224 in the main segment SEG concerned. Only one such dummy segment DSEG is shown in Fig. 3. The dummy DAC segment DSEG is constituted in the same basic way as its corresponding main segment. Thus, each dummy DAC segment DSEG comprises its own constant current source 216 which supplies a substantially constant current $I_{dummy}$ to a common node DCN of the dummy segment. The dummy segment DSEG further comprises respective first and second dummy switching transistors DS1 and DS2. The first dummy switching transistor DS1 is connected between the common node DCN and the first dummy DAC output node DON1 of the dummy segment, and the second dummy switching transistor DS2 is connected between the common node DCN and the second dummy output node DON2 of the dummy segment. The switching signal SW2 applied to the gate of the second switching transistor in the main segment SEG is applied to the gate of the first dummy switching transistor DS1 in the dummy segment DSEG. Similarly, the switching signal SW1 applied to the first switching transistor in the main segment is applied to the gate of the second dummy switching transistor DS2. Thus, when S1 and S2 are ON and OFF respectively, DS1 and DS2 are OFF and ON respectively.

The dummy DAC segment DSEG also comprises first and second resistors R1 and R2, each connected between the gate of one of the cascode transistors 222 and 224 and GND.

In operation of the Fig. 3 circuitry, the output-terminal potentials $V_A$ and $V_B$ vary in use of the circuitry in accordance with the applied binary input word. The first and second cascode transistors 222 and 224 serve to shield the main switching transistors S1 and S2 in each main segment from such potential variations. Each cascode transistor performs an active cascode function, in which the gate potential of the cascode transistor is varied in dependence upon the binary input word. The active cascodes operate as follows.

In the dummy DAC segment DSEG corresponding to each main segment SEG, the current $I_{dummy}$ sourced by the constant current source 16 is steered selectively to the resistor R1 or the resistor R2, depending on the states of the switching signals SW1 and SW2 of the main segment. Thus, when SW1 has the low logic level L and SW2 has the high logic level H, the current $I_{dummy}$ is steered to the resistor R2 by the second dummy switching transistor DS2, so that the gate potential of the second cascode transistor 224 has a positive value equal to the product of $I_{dummy}$ and the resistance of the second resistor R2.

In each main segment, the current flowing through each cascode transistor changes between a high value equal to $I+I_{BLEED}$ when its associated main switching transistor S1 or S2 is ON and a low value $I_{BLEED}$ when its associated switching transistor is OFF. The magnitude of the gate-source voltage of each cascode transistor varies in accordance with the current flowing through the cascode transistor concerned so that as the current increases the gate-source voltage magnitude also increases slightly (i.e. the source potential becomes more positive with respect to the gate potential). This in turn means that the potential of the intermediate node IN1 or IN2 to which the cascode transistor is connected also rises slightly when the associated main switching transistor SW1 or SW2 is ON.

In order to compensate for this rise in potential of the associated intermediate node IN1 or IN2, in the Fig. 3 circuitry, the dummy DAC segment DSEG causes the gate potential of each cascode transistor whose associated main switching transistor is ON to be lower than when its associated main switching transistor is OFF. The change in gate potential, from the OFF state to the ON state of the associated main switching transistor, is, for example, of the order of 150mV.

Although the active cascode arrangement of Figure 3 is partially effective, during actual switching of each segment a small fluctuation occurs in the drain potentials of the main switching transistors S1 and S2 because the gate potentials of the cascode transistors do not move fast enough to compensate completely for the changes in current flowing through the cascode transistors.

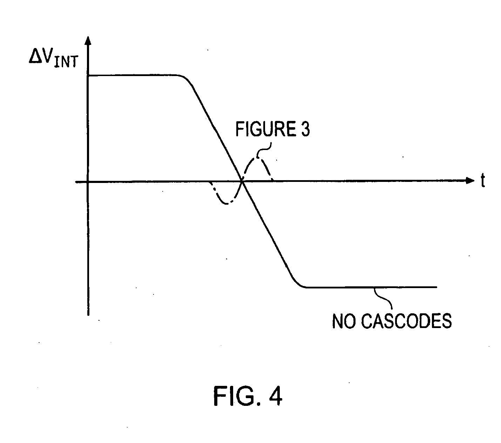

This effect is illustrated in Fig. 4 which compares the change in potential difference $\Delta V_{INT}$ between the main switching transistor drains in response to a change $\Delta V$ in potential difference between the output terminals OUTA and OUTB for the Fig. 2 circuitry (no cascodes) and the Figure 3 circuitry (active cascodes). When no cascodes are provided $\Delta V_{INT}$ is equal to $\Delta V$. When active cascodes are used, $\Delta V_{INT}$ undergoes a complementary variation to $\Delta V$, albeit of small

magnitude compared to ΔV itself. This complementary variation gives rise to signal-dependent delay, limiting the benefits of the active cascode arrangement. Another problem is that the active cascode arrangement requires a plurality of dummy DAC segments, and therefore is relatively complex to implement and has a high power consumption.

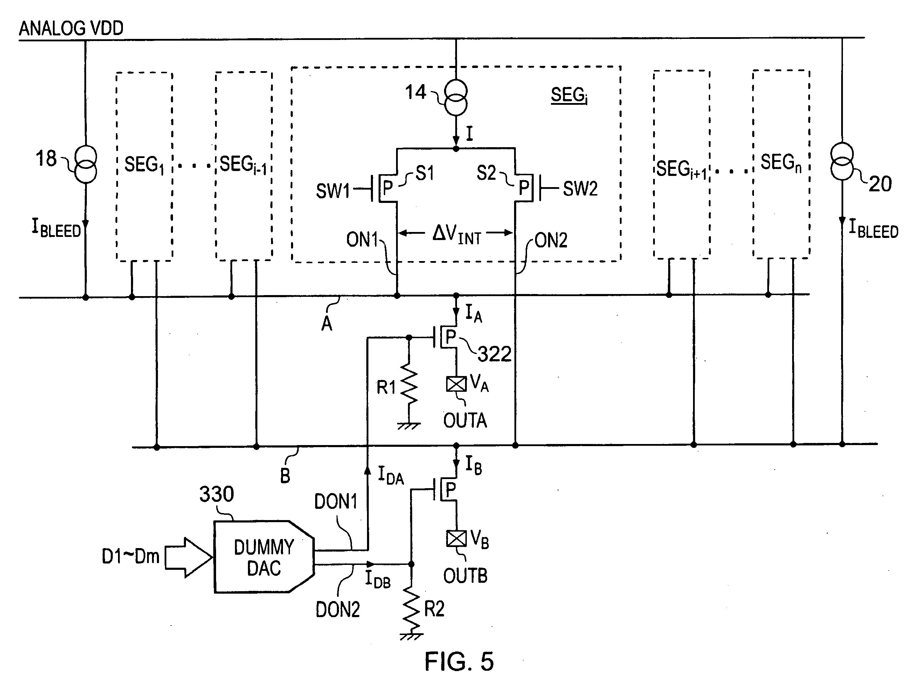

Another previously-considered shielding arrangement is shown in Figure 5. The Figure 5 circuitry also has active cascodes but, unlike in the Figure 3 example, the active cascodes are provided in a "common configuration", i.e. a single cascode per output node is used in common for all segments $SEG_1$ to $SEG_n$.

In the Fig. 5 circuitry, first and second cascode transistors 322 and 324 are connected between the connection lines A and B and the output terminals OUTA and OUTB. The gate of the first cascode transistor 322 is connected to a first output node DON1 of a dummy DAC circuit 330, and the gate of the second cascode transistor 324 is connected to a second output node DON2 of the dummy DAC circuit 330.

The dummy DAC circuit 330 supplies at its first output node DON1 a current $I_{DA}$ and supplies at its second output node DON2 a second output current $I_{DB}$. The dummy DAC circuit 330 receives at its input the same binary input word D1~Dm that is applied to the main DAC. The dummy DAC circuit 330 differs from the main DAC in that, when the binary input word has its lowest value, the output current $I_{DA}$ has its highest value and the output current $I_{DB}$ is zero. As the binary input word increases progressively in value, the output current $I_{DA}$ increases until, at the highest value of the binary input word, $I_{DA}$ is zero and $I_{DB}$ has its maximum value.

The effect of the dummy DAC circuit 330 is that, as in the Figure 3 example, the gate potential of each cascode transistor 322 or 324 reduces as the current flowing through the cascode transistor increases. This shields the output nodes ON1 and ON2 of the main segments from the effect of a rise in gate-source potential of each cascode transistor as the current flowing through the transistor increases.

In order for the shielding arrangements of Figures 3 and 5 to operate correctly it is necessary to match the resistors R1 and R2 to the output load, i.e. the load resistors connected to the output terminals OUTA and OUTB. These load resistors are external, so they may be varied deliberately or they may simply vary from their expected values because of temperature or other variations. If the external load resistors change from the desired values, the effectiveness of the shielding arrangements will decrease. Similarly, if the frequency response of the output load changes, then the shielding arrangements will also fail to operate correctly.

A further problem with the shielding arrangements of Figures 3 and 5 is that any non-linearity of the DAC (differential non-linearity DNL or integral non-linearity INL) will cause a signal-dependent error voltage at the segment output nodes ON1 and ON2.

Finally, the dummy DAC arrangements increase the power consumption and/or space occupied by the circuitry on the substrate, and it can be problematic to match the speed of the dummy DAC to that of the main DAC.

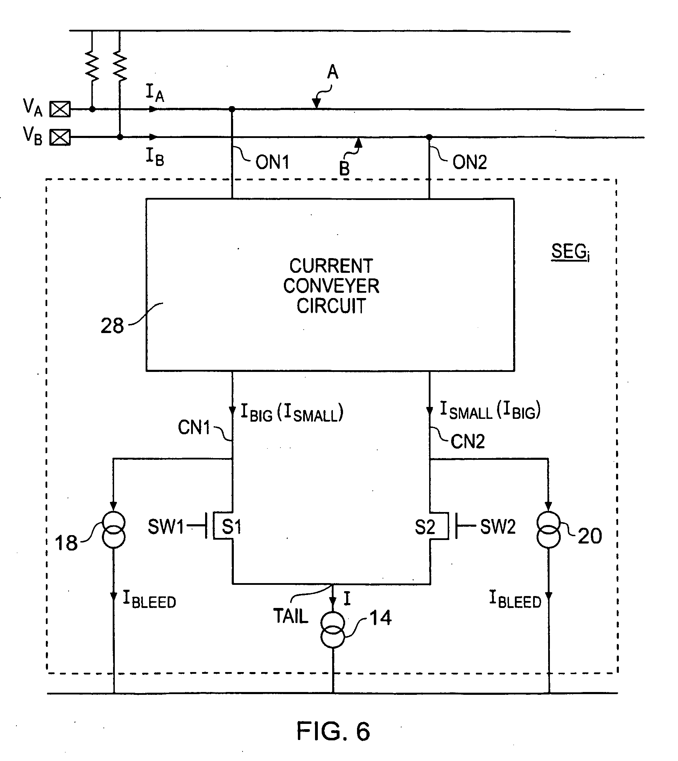

Fig. 6 shows an overview of current switching circuitry embodying the present invention. In Figure 6, parts which are the same as, or correspond closely to, parts described previously with reference to Figures 3 to 5, are denoted by the same reference numerals, and an explanation thereof is omitted.

The Figure 6 circuitry has a plurality of individual circuitry segments, only one of which $SEG_i$ is shown in detail in Figure 6. Each segment has a first main switching transistor

S1 having its source connected to a common node TAIL and its drain connected to a first connection node CN1 of the segment. Similarly, a second main switching transistor S2 has its source connected to the common node TAIL and its drain connected to a second connection node CN2 of the segment. Each main switching transistor is an NMOS FET in this example. The switching transistors S1 and S2 receive respectively at their gates mutually-complementary switching signals SW1 and SW2 generated by driver circuits (not shown) such as the driver circuit $6_1$ and $6_2$ in Figure 2.

Connected between the common node TAIL and a ground supply line ANALOGUE GND of the circuitry is a constant current sink 14 which causes a substantially constant current I to be supplied from the common node TAIL to the ground line ANALOGUE GND when the circuitry is in use.

Each of the connection nodes CN1 an CN2 is also connected to a bleed circuit 18 or 20. Each bleed circuit contains its own constant-current sink which draws a substantially constant current $I_{BLEED}$ from the connection node CN1 or CN2 to which it is connected to ANALOGUE GND. The constant currents $I_{BLEED}$ drawn from CN1 and CN2 by the bleed circuits 18 and 20 may each be, for example, approximately one quarter of the current I drawn from the common node TAIL by the constant current sink 14.

In the Figure 6 circuitry, the segment $SEG_i$ also has first and second output nodes ON1 and ON2. The respective first output nodes of all the segments are connected in common to a first connection line A of the circuitry, and the respective second output nodes ON2 of all segments are connected in common to a second connection line B of the circuitry. A first output terminal OUTA of the circuitry is connected to the first connection line A, and a second connection terminal OUTB of the circuitry is connected to the second connection line B.

The segment $SEG_i$ further comprises a current conveyor circuit 28 connected between the first and second output nodes ON1 and ON2 and the connection nodes CN1 and CN2. The purpose of the current conveyor circuit 28 is to shield the first and second connection nodes CN1 and CN2 from variations in potential arising from two different sources. The first source of the potential variations is variations in the respective potentials of the first and second output nodes ON1 and ON2. In use of the circuitry the potential $V_A$ or $V_B$ of each output terminal OUTA or OUTB inevitably varies in accordance with a current $I_A$ or $I_B$ flowing through the output terminal concerned. There can be large changes in these currents, and hence output voltages, from one cycle to the next. For example, if the binary input word changes from its full-scale negative value -FS to its full-scale positive value +FS the output current IA may change from, for example, 5mA (its value when the switching transistors S1 in all segments are OFF) to 25mA (its value when the switching transistors S1 in all segments are ON), whilst at the same time the output current $I_B$ falls from 25mA to 5mA. Depending on the output load impedance associated with each output terminal (shown schematically by resistors R1 and R2 in Figure 6), the change in potential $V_A$ or $V_B$ of each output terminal may be relatively large, for example 0.5V if each output load impedance is 25Ω. A difference ΔV between the output terminal potentials $V_A$ and $V_B$ changes by 1V in this case.

A second source of variations in potential in the connection nodes CN1 and CN2 is a variation dependent on the currents flowing through the main switching transistors S1 and S2. This variation is dependent on which of the transistors S1 and S2 is on and which is off in any given cycle. Accordingly, this variation will be referred to hereinafter as a variation dependent on the switching state of each segment. For example, as illustrated in Figure 6, when the transistor S1 is ON and the transistor S2 is OFF, the total current flowing through the first connection node CN1 is the sum of the currents flowing through the current sinks 14 and 18. This total current $I_{BIG}=I+I_{BLEED}$. The total current flowing through the second connection node CN2 at this time is the current flowing through the bleed current sink 20. Thus $I_{SMALL}=I_{BLEED}$.

When the switching state of the switching transistors S1 and S2 is reversed, it follows that the currents $I_{BIG}$ and $I_{SMALL}$ are swapped over so that $I_{SMALL}$ flows through the first connection node CN1 and $I_{BIG}$ flows through the second connection node CN2. In practice, these switching state-dependent variations in the currents flowing through the connection nodes CN1 and CN2 cause the potentials of the connection nodes CN1 and CN2 to exhibit switching-state-dependent variation.

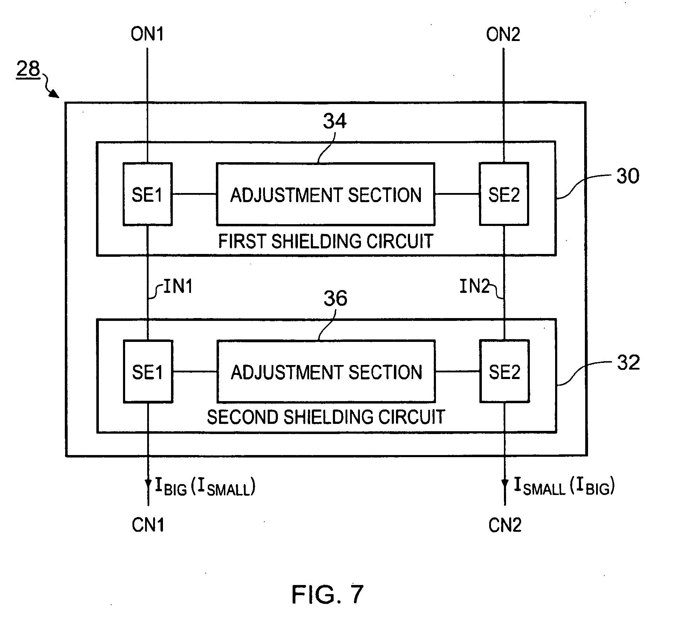

Figure 7 shows one possible implementation of the current conveyor circuit 28 in Figure 6. In Figure 7, the current conveyor circuit 28 comprises a first shielding circuit 30 and a second shielding circuit 32. Each shielding circuit 30 and 32 is of the same general construction and comprises a first shielding element SE1, a second shielding element SE2 and an adjustment section 34 or 36.

The first shielding element SE1 of the first shielding circuit 30 is connected between the first output node ON1 and a first intermediate node IN1. The first shielding element SE1 of the second shielding circuit 32 is connected between the intermediate node IN1 and the first connection node CN1. Similarly, the shielding element SE2 of the first shielding circuit 30 is connected between the second output node ON2 and a second intermediate node IN2. The second shielding element SE2 of the second shielding circuit 32 is connected between the second intermediate node IN2 and the second connection node CN2.

Accordingly, the two shielding elements SE1 are connected in series between the first output node ON1 and the first connection node CN1. When the switching transistor S1 is ON in the segment (Figure 6), it therefore follows that $I_{BIG}$ flows through each of the shielding elements SE1 in the first and second shielding circuits 30 and 32. The current $I_{SMALL}$ flows through each of the second shielding elements SE2 at this time. When the switching state of the segment is reversed, $I_{SMALL}$ flows through the two first switching elements SE1 and $I_{BIG}$ flows through the two second shielding elements SE2.

The first shielding circuit 30 is provided in order to shield the connection terminals CN 1 and CN2 from variations in potential that would otherwise arise from variations in the potentials at the output nodes ON1 and ON2. The adjustment section 34 in the first shielding circuit therefore adjusts the operation of the first and second shielding elements SE1 and SE2 in the first shielding circuit 30 to produce at the first and second intermediate nodes IN1 and IN2 respective potentials that are substantially independent of variations in the output-node potentials (or at least exhibit limited variation when the output-node potentials vary).

However, the first shielding circuit 30 does not remove the influence of the switching state on the connection-node potentials. This function is carried out by the second shielding circuit 32. Thus, the potentials of the intermediate nodes IN1 and IN2 still have a dependence on the switching state of the segment concerned. To remove the effect of the switching-state dependence, the adjustment section 36 in the second shielding circuit 32 adjusts the first and second shielding elements SE1 and SE2 in the second shielding circuit 32 so as to make the potentials of the first and second connection nodes CN1 and CN2 substantially independent of the switching state of the segment. Thus, not only are the connection-node potentials independent of the output-node potentials but they are also independent of the switching state of the segment.

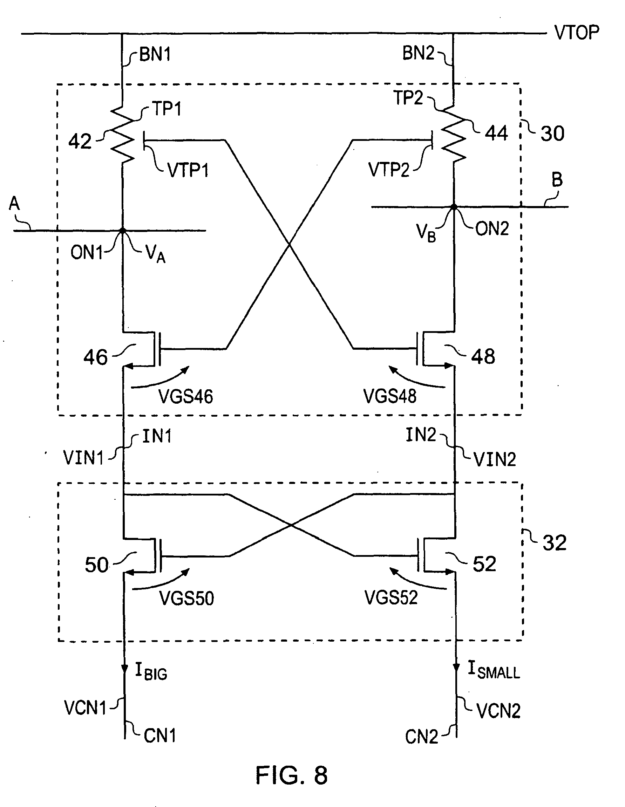

Figure 8 is a detailed circuit diagram of the current conveyor circuit 28 in a first embodiment of the present invention.

In the first embodiment the first shielding circuit 30 comprises first and second resistance elements 42 and 44 and first and second cascode transistors 46 and 48. These cascode transistors 46 and 48 correspond respectively to the first and second shielding elements SE1 and SE2 of the first shielding circuit in Figure 7. The first cascode transistor 46 has its drain connected to the first output node ON1 and its source connected to the first intermediate node IN1. The second cascode transistor 48 has its drain connected to the second output node ON2 and its source connected to the second intermediate node IN2. The first resistance element 42 is connected between the first output node ON1 and a first biasing node BN1. The second resistance element 44 is connected between the second output node ON2 and a second biasing node BN2. Both the biasing nodes BN1 and BN2 in this example are connected to a line which is maintained at a potential VTOP.

Each of the resistance elements 42 and 44 is a "tapped" element. An output from the first resistance element 42 is taken at a first tap point TP1 along the element. An output from the second resistance element 44 is taken from a second tap point TP2 along that element. The tap point TP1 is connected to a gate of the second cascode transistor 48, and the tap point TP2 is connected to a gate of the first cascode transistor 46. The tap points TP1 and TP2 are generally at the same position on their respective resistance elements 42 and 44, although in principle it would be possible to make the tap points differ so as to deal with any variations in the characteristics of the first and second cascode transistors 46 and 48.

The second shielding circuit 32 comprises first and second cascode transistors 50 and 52. These correspond respectively to the first and second switching elements SE1 and SE2 in the second shielding circuit 32 in Figure 7. A source of the first cascode transistor 50 is connected to the first connection node CN1, a drain of the first cascode transistor 50 is connected to the first intermediate node IN1, and a gate of the first cascode transistor 50 is connected to the second intermediate node IN2. A source of the second cascode transistor 52 is connected to the second connection node CN2, a drain of the second cascode transistor 52 is connected to the second intermediate node IN2 and a gate of the second cascode transistor 52 is connected to the first intermediate node IN1.

Each of the cascode transistors 46, 48, 50 and 52 is an NMOS FET in this example.

Operation of the circuitry of Figure 8 will now be explained.

Although the current flowing through each of the transistors 46 and 48 is substantially constant (for a given switching state), the drain-source voltage $V_{DS}$ for each of the transistors 46 and 48 changes because the drain voltage (the potential of the output node ON1 or the output node ON2) is varying significantly. This variation in drain-source voltage ($V_{DS}$) produces a smaller variation in $V_{GS}$ for each of the transistors 46 and 48.

The potential VTP1 at the first tap node TP1 is a scaled-down version of the potential VA at the output node ON1. Similarly, VTP2 at the second tap point TP2 is a scaled-down version of the potential VB at the second output node ON2. Here, each potential is measured relative to the potential VTOP of the biasing nodes BN1 and BN2. The amount of scaling is adjusted (selected) by moving the tap point TP1 or TP2 in the relevant resistance element 42 or 44.

The connections from the tap points TP1 and TP2 to the gates of the cascode transistors 48 and 46 respectively cause the gate of each cascode transistor 46 and 48 to have a potential which tracks the variation of a gate-source voltage $V_{GS}$ of the transistor concerned but whose slope is in the opposite direction. Accordingly, the tap point TP1 in the first resistance element 42 is adjusted so that, as the potential VB varies, the change in the gate voltage of the transistor 48 is the same magnitude as the change in the gate-source voltage VGS48 of the transistor concerned but in the opposite direction. Similarly, the tap point TP2 in the second resistance element 44 is adjusted so that, as the potential VA of the first output node ON1 varies, the change in the gate voltage of the transistor 46 is the same magnitude as the change in the gate-source voltage VGS46 of the transistor concerned but in the opposite direction. This results in a first-order cancellation of the dependence of VGS46 on the potential VA and a similar cancellation of the dependence of VGS48 on the potential VB. Thus, the potentials at the respective sources of the transistors 46 and 48 (i.e. the potentials VIN1 and VIN2 are substantially constant, irrespective of the output of the circuitry.

The potentials VIN1 and VIN2 will not be equal to one another, however, because the currents flowing through the two transistors 46 and 48 will not be equal. For example, if the segment is in the switching state shown in Figure 6, then the current flowing through the transistor 46 will be $I_{BIG}$ ($=I+I_{BLEED}$), whereas the current flowing through the transistor 48 will be $I_{SMALL}$ ($=I_{BLEED}$). This means that VGS46 is greater than VGS48 in this switching state. The reason for this is that $V_{GS} = V_T+V_{DS}(SAT)$. The parameter $V_{DS(SAT)}$ is proportional to the square root of the current flowing through the transistor channel. Accordingly, $V_{GS}$ changes with the current flowing through the channel.

Thus, VGS46 has a switching-state-dependent component that has a high value in a first switching state (S1 ON, S2 OFF) and a low value in a second switching state (S1 OFF, S 2ON). Similarly, VGS48 has a switching-state-dependent component that has a high value in the second switching state and a low value in the first switching state.

To eliminate the effects of these switching-state-dependent components of VGS46 and VGS48 on the potentials of the connection nodes CN1 and CN2, the second shielding circuit 32 is provided. The transistors 50 and 52 in the second shielding circuit 32 have the same current mismatch as the transistors 46 and 48 in the first shielding circuit 30. Each of the transistors 50 and 52 also has a component of its gate-source voltage that is dependent on the switching state of the segment. Thus, the gate-source voltage VGS50 of the transistor 50 has a switching-state-dependent component that has a high value in the first switching state and a low value in the second switching state. Similarly, the gate-source voltage VGS52 of the transistor 52 has a switching-state-dependent component that has a low value in the first switching state and a high value in the second switching state. By cross-coupling the gate of the transistor 50 to the source of the transistor 48 (the second intermediate node IN2) the switching-state-dependent component of the transistor 50 works to cancel out the switching-state-dependent component of VGS 48. In other words, when the switching-state-dependent component of VGS48 is high the switching-state-dependent component of VGS50 is low, and vice versa. This means that the sum of the respective switching-state-dependent components of VGS48 and VGS50 should always be the same whatever the switching state of the segment.

The same is true for VGS46 and VGS52. The sum of the respective switching-state-dependent components of the VGS46 and VGS50 should always be the same whatever the switching state of the segment.

In this way, it can be ensured that the potential of the first connection node CN1 is substantially constant across the entire range of output-node potentials irrespective of the switching state. Similarly, the potential of the second connection node CN2 also is substantially constant across the entire output range, irrespective of the switching state. Also, the potentials at the connection nodes CN1 and CN2 will be substantially equal to one another across the entire output range and for any switching state.

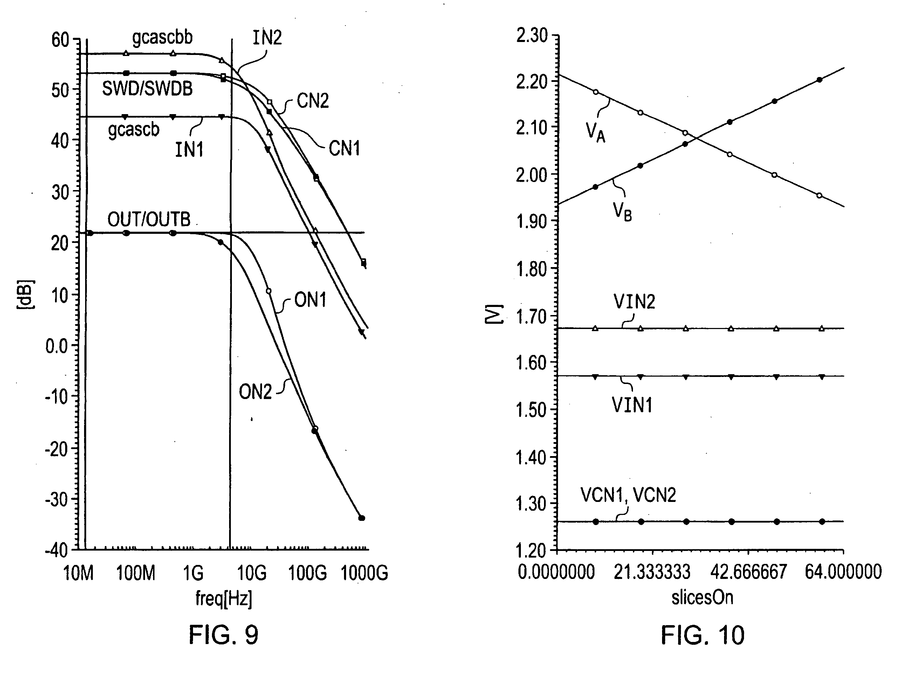

Figure 9 presents simulation results relating to an AC performance of the circuitry of Figure 8. In Figure 9, the horizontal axis represents frequency on a logarithmic scale. The vertical axis represents impedance measured in decibels (dB).

For the purpose of this simulation, it is assumed that a segment under consideration is in the first switching state (S1 ON, S2 OFF). For the simulation, an AC current source is connected between nodes CN1 and CN2 of the considered segment. The AC simulation results shown in Figure 9 represent the impedance seen looking into the indicated nodes.

For example, consider the output nodes ON1 and ON2. In the simulation, these nodes are each connected to corresponding nodes in 63 other segments (i.e. to 64 segments in total), each having resistances 42 and 44 to VTOP equal to 1.6KΩ. The 64 similar resistances for each node are in parallel with one another, providing an equivalent resistance of 25Ω for each node. Also in the simulation, an external resistance of 25Ω is provided for each output node, giving a total resistance of 12.5Ω between each of nodes ON1 and ON2 and VTOP.

Also looking into output nodes ON1 and ON2, there is the impedance of the cascode structure, which is very high as nodes CN1 and CN2 have a small dependence on VA and VB. Accordingly, at low frequencies such as at DC, a resistance of 12.5Ω in parallel with the output cascode appears as 12.5Ω (the resistance dominates). The impedance 12.5Ω in dB is around 22 dB (20 log 12.5 = 21.9 dB). Thus, the traces for output nodes ON1 and ON 2 in Figure 9 have an impedance of about 22dB at DC.

In Figure 9, the impedances at the various nodes roll off at high frequency because the impedance of the parasitic capacitances reduce at high frequencies and thus become dominant.

From Figure 9 it can be seen that no significant variation in the impedance looking into nodes CN1 and CN2 occurs at any frequency up to 6GHz.

Figure 10 presents simulation results relating to a DC performance of the Figure 8 circuitry. For the purposes of this simulation, it is assumed that a segment under consideration is in the first switching state (S1 ON, S2 OFF). In this state, VGS46 is greater than VGS48 so that VIN2 is greater than VIN1. It is then assumed that the switching states of the remaining segments are changed progressively (a sweep), starting with all of the segments in the second switching state and ending with all of the segments in the first switching state. Over the course of this sweep, VA falls progressively from around 2.22V to around 1.94V, and VB rises progressively from around 1.94V to around 2.22V. As can be seen from Figure 10, over the course of this sweep, VIN1 remains constant at around 1.57V and VIN2 remains constant at around 1.68V. It can also be seen that VCN1 and VCN2 are each substantially constant and are substantially equal to one another (around 1.26V) over the course of the entire sweep. There is less than 1 mv variation in VCN1 and VCN2 over the entire sweep.

Accordingly, the Figure 8 circuitry is capable of maintaining each of the potentials of the connection nodes CN1 and CN2 substantially constant and substantially equal to one another independent of variations in the output-node potentials and independent of the switching state of the segment.

In the Figure 8 circuitry, the sizes of the transistors 50 and 52 need to be chosen suitably in order that the changes in their switching-state-dependent VGS components match the changes in the switching-state-dependent VGS components of the transistors 46 and 48. For example, each of the transistors 50 and 52 is connected in a source follower configuration. A gain G of the source follower is approximately $g_m/(g_{ds}+g_m) = 1/(1+(g_{ds}/g_m))$, where $g_m$ is the transconductance and $g_{ds}$ is the drain conductance. The transconductance $g_m$ is the ratio $i_d/v_{gs}$, i.e. the change in drain current for a given change in gate-source voltage. The drain conductance $g_{ds}$ is the ratio $i_d/v_{ds}$, i.e. the change in drain current for a given change in drain source voltage. Here, an effect of the bulk voltage on the gain is ignored on the assumption that the source-bulk voltage is small.

The potentials VIN1 and VIN2 at the intermediate nodes IN1 and IN2 are different because the drain-source saturation voltages $V_{DS(sat)}$ of the transistors 46 and 48 differ. The drain-source saturation voltage $V_{DS(sat)}$ is proportional to the square root of the drain current I, and the drain currents of the transistors 46 and 48 are different. The gate-source voltage $V_{GS}=V_{T}+V_{DS(sat)}$, where $V_T$ is the threshold voltage.

In the source-follower arrangement of cascode transistors in Figure 8, it will be appreciated that when the segment concerned is in the first switching state (S1 ON, S2 OFF), $V_{DS(sat)}$ for transistors 46 and 50 will be big (hereinafter $V_{DS(sat)\text{-}BIG\text{-}46}$ and $V_{DS(sat)\text{-}BIG\text{-}50}$), and $V_{DS(sat)}$ for transistors 48 and 52 will be small (hereinafter $V_{DS(sat)\text{-}SMALL\text{-}48}$ and $V_{DS(sat)\text{-}SMALL\text{-}52}$). It will further be appreciated that if cascode transistors 50 and 52 were of the same size as cascode transistors 46 and 48, then $V_{DS(sat)\text{-}BIG\text{-}46} = V_{DS(sat)\text{-}BIG\text{-}46}$, and similarly $V_{DS(sat)\text{-}SMALL\text{-}48} = V_{DS(sat)\text{-}SMALL\text{-}52}$.

In this source-follower arrangement:

$$VCN1 \% V_{DS(sat)\text{-}BIG\text{-}50} + G(V_{DS(sat)\text{-}SMALL\text{-}48})$$

$$VCN2 \% V_{DS(sat)\text{-}SMALL\text{-}52} + G(V_{DS(sat)\text{-}BIG\text{-}46})$$

where G is the gain of the source-follower arrangement.

Based on the above, it can be seen that if the source-follower arrangement has an ideal unity gain (G=1), and the cascode transistors 50 and 52 are of the same size as cascode transistors 46 and 48, then effectively VCN1 = VCN2. However, with the same sized transistors, if the gain G is lower than 1, for example 0.8 (as might be expected in practice), then it will be appreciated that effectively VCN1≠VCN2, which would leave an undesirable error voltage between nodes CN1 and CN2.

One way to compensate for such a reduced gain G (e.g. G = 0.8) is to reduce $V_{DS(Sat)}$ for transistors 50 and 52 (as compared to transistors 46 and 48), by multiplying them by factor G to get $V_{DS(sat)\text{-}F50/52} = G(V_{DS(sat)\text{-}46/48})$, that is, to get:

$$V_{DS(sat)\text{-}BIG\text{-}50} = G(V_{DS(sat)\text{-}BIG\text{-}46})$$

$$V_{DS(sat)\text{-}SMALL\text{-}52} = G(V_{DS(sat)\text{-}SMALL\text{-}48})$$

In this way, the equations for VCN1 and VCN2 become:

$$VCN1 \% G (V_{DS(sat)\text{-}BIG\text{-}46} + V_{DS(sat)\text{-}SMALL\text{-}48})$$

$$VCN2 \% G (V_{DS(sat)\text{-}SMALL\text{-}48} + V_{DS(sat)\text{-}BIG\text{-}46})$$

That is, in this way effectively VCN1 = VCN2 again, regardless of the value of gain G, and the undesirable error voltage between nodes CN1 and CN2 is avoided. In order to reduce $V_{DS(sat)}$ for transistors 50 and 52 (as compared to transistors 46 and 48), by multiplying them by factor G, the following is to be considered.

The drain-source saturation voltage $V_{DS(rat)} = \sqrt{(2 l L / kW)}$. It follows that $G.V_{DS(sat)} = \sqrt{((2l/k).G^2.(LW))}$. Therefore, to compensate for the lower gain of the source follower, it is possible to employ $(W/L)_{50,52} = (W/L)_{46,48}/G^2$, where $(W/L)_{50,52}$ is the width-to-length ratio of transistors 50 and 52 and $(W/L)_{46,48}$ is the width-to-length ratio of transistors 46 and 48.

For example, if G = 0.8, $(W/L)_{50,52}$ of the transistors 50 and 52 should be approximately 1.5 times (=$1/0.8^2$) $(W/L)_{46,48}$ of the transistors 46 and 48. In this way, $V_{DS(sat)}$ of each of the transistors 50 and 52 is effectively multiplied by G = 0.8 as compared to that of transistors 46 and 48, i.e. reduced in comparison.

In practice, $g_m/g_{ds}$ can vary significantly from one transistor to another with process, voltage and temperature.

Table 1 below shows how this variation affects the Figure 8 circuitry. In this example, it is assumed that $g_m/g_{ds}$ is intended to be 5, but that because of variations between the transistors, the value of $g_m/g_{ds}$ changes to 4 and 6, i.e.

a variation of $\pm$ 20%. If $g_m/g_{ds}$ without the transistors 50 and 52, this would lead to an uncancelled error in the potentials VCN1 and VCN2 of 0.2. With the cascode transistors 50 and 52 present, this error is cancelled out entirely. However, if $g_m/g_{ds}$ is 4, then the uncancelled error would be 0.25. Because the cascode transistors 50 and 52 cannot then cancel out the error entirely, there is a residual error in the potentials VCN1 and VCN2 of +0.05. Similarly, if $g_m/g_{ds}$ changes to 6, then the uncancelled error would be 0.16. With the cascode transistors 50 and 52 present, the residual error is -0.04. It can therefore be seen from Table 1 that even if the ratio between the widths of the transistors 50 and 52 and the transistors 46 and 48 is not set absolutely correctly, there will still be a significant reduction in the error at the potentials of the connection nodes CN1 and CN2 (a factor of 4 or 5 reduction in the example given above).

**Table 1**

| $g_m/g_{ds}$ | Without first shielding circuit | With first shielding circuit |
|---|---|---|
| 5 | 0.2 | 0 |
| 4 | 0.25 | +0.05 |
| 6 | 0.16 | -0.04 |

In the Figure 8 circuitry, each of the tap points TP1 and TP2 could be adjusted to compensate for variations in $g_m/g_{ds}$ of the transistors 46 and 48, as noted above.

The bandwidth of each of the transistors 50 and 52 is a function of the transconductance $g_m$ of each of those transistors. This in turn is a function of the current flowing through the transistor concerned. In order to maintain the bandwidth of each of the transistors 50 and 52 at a sufficiently high level even when it has the lower current $I_{SMALL}$ flowing through it, $I_{BLEED}$ needs to be around 0.2 or more of the current I that is switched by the segment.

Although Figure 8 shows an individual pair of resistance elements 42 and 44 is provided for a segment, it is also possible to share a pair of resistance elements 42 and 44 among all of the segments, or amongst a group of the segments.

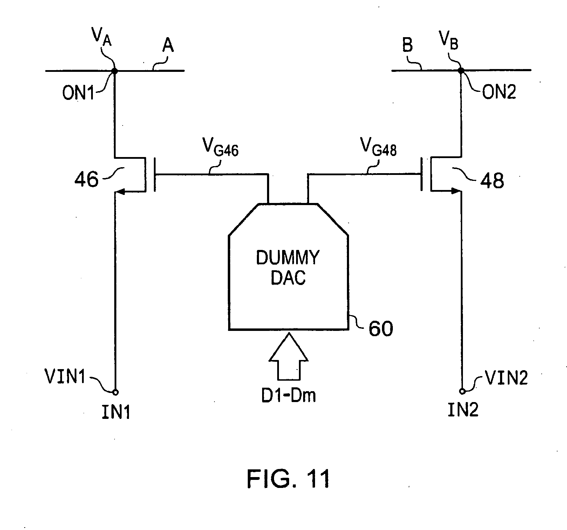

In the Figure 8 embodiment, the dependence of the intermediate node potentials VIN1 and VIN2 on the output-node potentials VA and VB is removed or reduced by using the tapped resistors 42 and 44. However, it is not essential to use tapped resistors to achieve this result. For example, Figure 11 shows another possible implementation of the first shielding circuit 30. In this implementation, the tapped resistors 42 and 44 are dispensed with and instead a dummy DAC 60 is provided to supply the gate potentials to the cascode transistors 46 and 48 (first and second shielding elements SE1 and SE2 in Figure 7). The dummy DAC 60 is supplied with the same digital input value D1~Dm as the main DAC in Figure 1. This digital input value D1~Dm of course determines the output node potentials VA and VB in operation of the DAC as a whole. Accordingly, by applying the same digital value to the dummy DAC the dummy DAC can generate suitable gate potentials $V_{G46}$ and $V_{G48}$ for the cascode transistors 46 and 48 to ensure that, as VA and VB change, the intermediate node potentials VIN1 and VIN2 remain substantially constant and independent of the variation in VA and VB. Further details of such a dummy DAC can be found in the applicant's earlier patent publication GB-A-2356302.

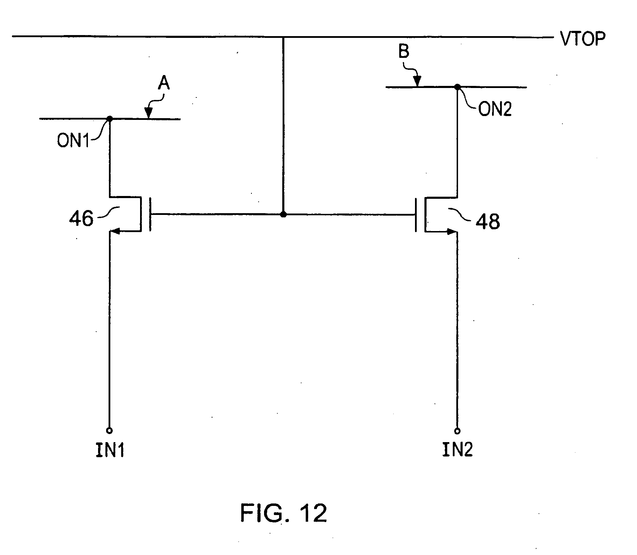

Another possible implementation of the first shielding circuit 30 is shown in Figure 12. In this implementation, the gate potentials of the cascode transistors 46 and 48 (first and second shielding elements SE1 and SE2 in Figure 7) are simply fixed to a predetermined biasing potential VTOP. This means that the cascode transistors 46 and 48 operate passively, rather than actively as in the examples of Figure 8 and Figure 11. However, even such passive cascodes can still achieve some reduction in the dependence of the intermediate-node potentials VIN1 and VIN2 on the output-node potentials VA and VB.

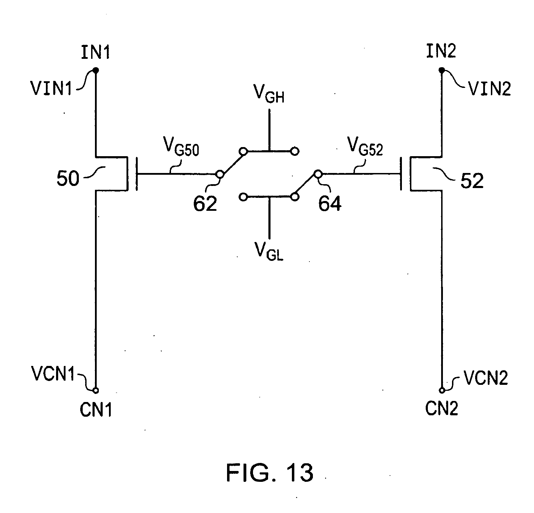

In the Figure 8 circuitry, the effect of the switching-state-dependent variations on the connection-node potentials VCN1 and VCN2 is removed by cross-coupling the cascode transistors 50 and 52. However, the same result can be achieved in other ways than cross-coupling the transistors. Figure 13 shows another possible implementation of the second shielding circuit 32. In this example, the second shielding circuit 30 generates a high gate potential $V_{GH}$ and a low gate potential $V_{GL}$. The potentials $V_{GH}$ and $V_{GL}$ differ from one another by a fixed amount. The gate potentials $V_{GH}$ and $V_{GL}$ should preferably track $V_{DS(sat)}$. For example, $V_{GH}$ should be proportional to $V_{DS(sat)BIG}$ and $V_{GL}$ should be proportional to $V_{DS(sat)SMALL}$. The second shielding circuit 30 in this example comprises first and second selection switches 62 and 64. The first selection switch 62 is connected to a gate of the cascode transistor 50 and, depending on the position of the switch 62, causes one of the potentials $V_{GH}$ or $V_{GL}$ to be applied to the gate as the gate potential $V_{G50}$. Similarly, the second selection switch 64 is connected to the gate of the transistor 52 and causes the other of the potentials $V_{GH}$ or $V_{GL}$ to be applied to the gate as the gate potential $V_{G52}$. The positions of the first and second selection switches 62 and 64 may be controlled by the signals SW1 and SW2 supplied to the main switching transistors in the segment concerned (S1 and S2 in Figure 5). For example, in the switching state shown in Figure 8 ($I_{BIG}$ flowing through the first connection node CN1), the switching-state-dependent components of VGS46 and VGS50 are both at their respective high values. This means that the value of the gate potential $V_{G50}$ of the transistor 50 needs to be increased relative to the value of the gate potential $V_{G52}$. Thus $V_{G50}$ is set to $V_{GH}$ and $V_{G52}$ is set to $V_{GL}$.

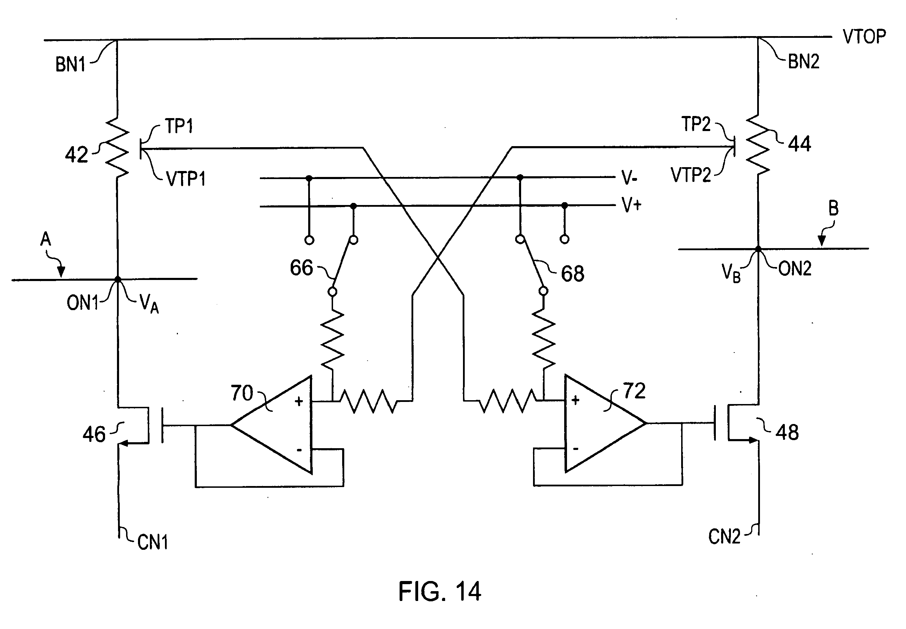

It is possible to use a single cascode transistor for each connection node CN1 and CN2 and adjust its gate voltage not only to take account of VOUT variations but also switching state variations. An example is shown schematically in Figure 14. In Figure 14, the cascode transistors 50 and 52 are omitted and only the cascode transistors 46 and 48 are used. The gate potential of the cascode transistor 46 is provided by a non-inverting amplifier 70. The non-inverting input of the amplifier 70 is connected via a resistor to the tap point TP2 in the resistance element 44. The non-inverting input is also connected by another resistor to an output of a selection switch 66. A first input of the selection switch 66 is connected to a low biasing potential V- and a second input of the selection switch 66 is connected to a high biasing potential V+. The selection switch 66 is controlled by the switching signal SW1 applied to the main switching transistor S1 in the segment. The amplifier 70 adds or subtracts a switching-state dependent component ΔV to or from the potential VTP2 of the tap point TP2. In this way, the gate potential of the transistor 46 is adjusted in dependence not only on the output-node potential VB but also on the switching state. The gate potential of the cascode transistor 48 is provided by another non-inverting amplifier 72 which operates in basically the same way as the amplifier 70.

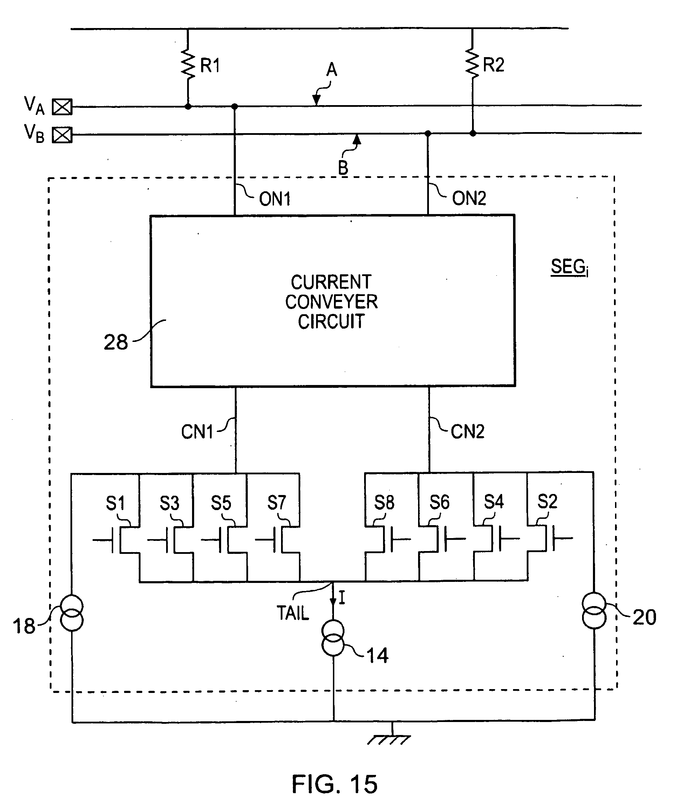

Next, another embodiment of the present invention will be described in which the differential switching circuitry in each segment is modified to have more than one transistor per output node. For example, as shown in Figure 15, four transistors S1, S3, S5 and S7 are connected in parallel between a common node TAIL and a first connection node CN1. Similarly, four transistors S2, S4, S6 and S8 are connected in parallel between the common node TAIL and a second connection node CN2. The differential switching circuitry in this case operates in a repeating series of four phases.

In the first phase, one of the pair of switches S1 and S2 is turned on and the other switch of that pair is turned off in dependence upon a data signal. All of the remaining switches S3 to S8 are maintained in the off state in the first phase.

In the second phase, the switches S1 and S2 are turned off. One of the switches of the pair of switches S3 and S4 is turned on and the other switch of that pair is turned off in dependence upon the data signal. The switches S5 to S8 remain off.

In the third phase, the switches S3 and S4 are turned off and one of the switches of the pair of switches S5 and S6 is turned on and the other switch of that pair is turned off in dependence upon the data signal. The switches S1, S2, S7 and S8 remain off.

Finally, in the fourth phase, the switches S5 and S6 are turned off. One of the switches of the pair of switches S7 and S8 is turned on and the other switch of that pair is turned off in dependence upon the data signal. The remaining switches S1 to S4 remain off. The fourth phase in this cycle is then followed by the first phase of the next cycle, and so on in a repeating manner.

It will be understood that, with this switching arrangement, only one of the switches S1 to S8 is on at any given time, and all of the remaining switches are turned off. Accordingly, the outputs from the differential switching circuitry of Figure 15 are the same as if only one pair of switches was provided as in Figure 5. However, because of the plural switches per output node, it can be arranged that, irrespective of the change in the data signal from one phase to the next, the same number of switches change state. For example, if in the first phase the switch S1 is on and the switch S2 is off and the data signal remains the same in the second phase, the switch S1 will turn off at the beginning of the second phase and the switch S3 will turn on. This means that one switch is always turning on at the same time as another switch is turning off. In the Figure 2 circuitry, there is no change in the switch state if the data signal stays the same from one cycle to the next.

The Figure 15 arrangement can assist in solving the problem of third-order distortion in a DAC. Third order distortion is particularly undesirable in DACs which produce multi-tone output signals, since third order intermodulation distortion may occur in-band, in which case it cannot be removed by filtering. The third order distortion is believed to be due in part to currents flowing into and out of parasitic capacitances which are present in the differential switching circuitry. By arranging for the same number of switches to change state from one phase to the next, the charge which flows into and out of the parasitic capacitances becomes less dependent on the input data signal. This helps to reduce third order distortion in the analogue output signal. Also, by arranging the same number of switches to change state in each cycle, the current drawn by each analogue segment is approximately the same in each cycle. This may help to reduce variations in the timings of the switching operations of the various analogue segments and thereby reduce distortion.

Further details of the Figure 15 circuitry may be found, for example, in the applicant's earlier patent publication EP-A-1292035, the entire content of which is incorporated herein by reference.

Incidentally, although Figure 15 shows an example in which there are four switches per output node, the number of switches is not limited to four and two or more switches may be provided per output node.

In the Figure 15 circuitry, the segment also has a current conveyor circuit 28 which is connected and operates in the same way as described previously with reference to Figure 6.

The Figure 8 circuitry will now be considered further. In particular, a number of design-considerations regarding that circuitry will now be addressed.

It has been found that in practice the tap points TP1 and TP2 in resistance elements 42 and 44 may need to be about 1/16 from the top of the resistance element concerned.

For example, the current switching circuitry may have 64 segments and have a target output resistance of 25Ω on each output node (ON1 and ON2). In that case, resistance elements 42 and 44 in each segment may have a resistance of 1.6KΩ (25 X 64). The 64 segments may however be arranged in 16 segment groups, each having 4 segments. The segments in each segment group may share one set of resistance elements 42 and 44 between them. In that case, resistance elements 42 and 44 in each segment group may have a resistance of 400Ω (25 X 16).

In the case of resistances of 400Ω, then the resistance above each tap point TP1/TP2 may need to be 25Ω (400Ω/16), and the resistance below each tap point TP1/TP2 may need to be 375Ω (400Ω x (15/16)). The resistance 25Ω is rather small in value and is not easy to create on silicon with a desirable low parasitic capacitance. In practice, in order to realise such a low resistance on silicon, many higher value resistances would need to be connected in parallel. This would lead to a relatively high area for the 25Ω resistance, and a corresponding large associated parasitic capacitance in each of the 16 segment groups.

Another design-consideration regarding the Figure 8 circuitry will now be discussed, again using the example circuitry having 64 segments.

For the sake of argument, it is assumed that a segment under consideration has a constant output signal, i.e. it remains in a constant switching state. It is then assumed that the other 63 segments all change switching state from one of the switching states to the other at the same time, giving a full scale output swing.

Ideally, as will be appreciated from the above, the voltage levels VCN1 and VCN2 at nodes CN1 and CN2 in the segment under consideration should not move. However, due to finite bandwidth in the source-follower loops controlling the voltage levels at TP1 and TP2, some ripple appears on the voltage levels VCN1 and VCN2 when the output voltages VA and VB, at output nodes ON1 and ON2, change.

For example, if voltage VA at node ON1 falls by 200mV, voltage level VIN1 at node IN1 will immediately try to track this. Being a differential output circuit, at the same time, voltage VB at node ON2 will rise by 200mV. If the voltage level VTP2 at tap point TP2 reacted to the corresponding 200mV rise in voltage VB with no delay, then voltage VIN1 would be prevented from tracking voltage VA, and would not fall. However, due to the delay around this loop, voltage VIN1 may actually drop by, for example, 100mV before recovering once the ON2→TP2 loop catches up. This 100mV drop in voltage VIN1 will cause voltage VCN2 at node CN2 to track it, for example causing voltage VCN2 to drop by 60mV before recovering.

It will of course be appreciated that a similar analysis could be carried out starting from the corresponding 200mV rise in voltage VB at node ON2, resulting in voltage VIN2 at node IN2 rising by 100mV and voltage VCN1 at node CN1 rising by 60mV until recovery.

That is, it will be appreciated that the voltages VCN1 and VCN2 at nodes CN1 and CN2 will experience a circuit-output-switching-state dependent ripple.

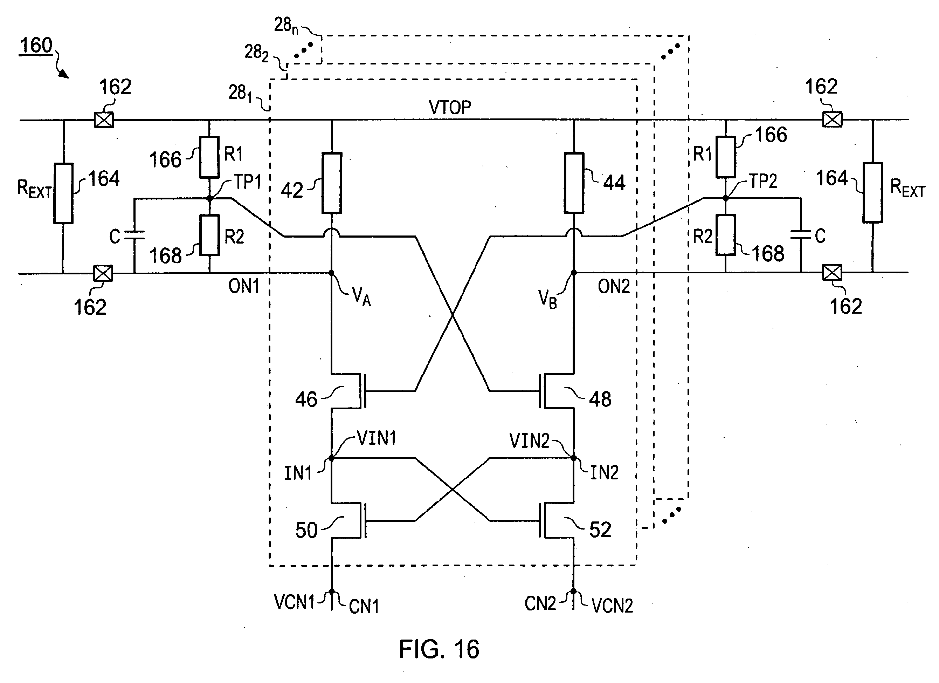

Figure 16 is a schematic diagram 160 representing circuitry for addressing the above-identified design considerations regarding the Figure 8 circuitry. It will be appreciated that the Figure 16 circuitry is closely similar to that of Figure 8, and accordingly, similar elements are denoted in the same way.

In the Figure 16 circuitry, sets of current conveyor circuitry $28_1$ to $28_n$ for n segments are provided, although only the current conveyor circuitry $28_1$ is clearly shown for clarity.

The signal lines VTOP, ON1 and ON2 are connected in common between all sets of current conveyor circuitry, to output terminals 162. External resistors $R_{EXT}$ 164 are provided between the left-hand pair of output terminals 162 for VTOP and ON1 and between the right-hand pair of output terminals for VTOP and ON2.

The main difference between the Figure 16 circuitry and the Figure 8 circuitry is that a single potential divider formed of resistance elements R1 166 and R2 168 is provided between VTOP and ON1, and a similar single potential divider is provided between VTOP and ON2. Further, the node between resistance elements R1 and R2 of the left-hand potential divider acts as a shared tap point TP1 for all sets of current conveyor circuitry $28_1$ to $28_n$, and similarly the node between resistance elements R1 and R2 of the right-hand potential divider acts as a shared tap point TP2 for all sets of current conveyor circuitry $28_1$ to $28_n$.

Accordingly, no tap points TP1 and TP2 are provided per set of current conveyor circuitry, and instead all tap point connections (to the gates of transistors 46 and 48) are made instead to the corresponding shared tap points TP1 and TP2.

A capacitance C is connected between shared tap point TP1 and ON1, and another such capacitance C is connected between shared tap point TP2 and ON2.

By having only one such potential divider per output ON1/ON2, it is possible to set the values of R1 and R2 to large values to position the tap point 1/16 from VTOP as before. For example, having R1 as 50Ω and R2 as 750Ω would be better than requiring a 25Ω resistor (in place of R1 in each segment as before). Also because there is only one potential divider per output, the associated parasitic capacitance will not be that significant.

A further advantage of having only one potential divider per output, i.e. at the "top level" rather than per segment, is that it becomes easier to make the "position" of the tap point (i.e. the level of division provided) adjustable. This may be beneficial if, for example, simulated $g_m/g_{ds}$ models do not match an actual fabricated circuit. Possible methods of adjustment will be described below.

The addition of the capacitances C effectively adds a zero into the finite bandwidth of the ON2→TP2 and ON1→TP1 loops, i.e. the capacitances C form low impedance paths at high frequency. Simulations show that a value of 200fF for C, in parallel with the suggested 750Ω for R2, reduces the ripple on voltages VCN1 and VCN2 in the example case from ±60mV to ±12mV.

It will be appreciated that the values of R1, R2 and C may be adjusted to provide an optimised trade-off between parasitic capacitance (which is dependent on resistor area) and ease of resistor fabrication, with the product R2 x C being optimised for ripple reduction.

It will of course be appreciated that the technique of employing capacitors C in the Figure 16 circuitry to effectively add a zero into the finite bandwidth of the ON2→TP2 and ON1→TP1 loops (to reduce voltage ripple at nodes CN1 and CN2) could be employed on a per segment basis, for example in the Figure 8 circuitry. In that case, capacitors C would be required between the tap points TP1/TP2 and the output nodes ON1/ON2 in each segment. In practice, however, this would lead to a large capacitance on the output nodes, which is undesirable.

It is possible to compare the use of "global" capacitors C in the Figure 16 circuitry with the use of "per segment" capacitors C in the Figure 8 circuitry, as follows.

In the case of "per segment" capacitors C in the Figure 8 circuitry, with tap points TP1 and TP2 per segment group, then the overall circuitry has (continuing the above example case) a resistance of R = 375 Ω in series with the gate capacitance $C_G$ of each of the top cascode devices (transistors 46 and 48). It is this $RC_G$ that gives the pole in respect of which the capacitance C is employed to provide a complimentary zero. This pole may therefore be considered to be located at $1/(2*pi*375*4C_G)$, where $C_G$ is the gate capacitance of each of the top cascode devices (transistors 46 and 48) in a single segment, the term $4C_G$ therefore representing the example segment group of four segments.

In the case of "global" capacitors C in the Figure 16 circuitry, with shared tap points TP1 and TP2, then the overall circuitry has (continuing the above example case) a resistance of R = 750 Ω in series with the gate capacitance $C_G$ of the top cascode devices (transistors 46 and 48) in 64 parallel-connected segments. The pole in this case may therefore be considered to be located at $1/(2*pi*750*64C)$.

As can be seen from the above, the Figure 16 circuitry arrangement has a substantially lower bandwidth than the Figure 8 circuitry arrangement. In each case, employing the capacitors C to provide the complimentary zeros can reduce voltage ripple at nodes CN1/CN2, however the overall effectiveness of the circuits is sample-rate dependent due to the different bandwidths. For example, in high sample-rate circuitry, it can be preferable from a bandwidth point of view to employ the Figure 8 circuitry arrangement with "per segment" capacitors C to reduce voltage ripple, rather than the Figure 16 circuitry with "global" capacitors C. However, as already mentioned, the Figure 8 circuitry arrangement with "per segment" capacitors C involves undesirably loading the output nodes with a high capacitive load. Accordingly, at high sample rates it can be preferable to employ the Figure 8 circuitry arrangement without "per segment" capacitors C and accept some residual voltage ripple at nodes CN1/CN2, rather than either the Figure 8 circuitry arrangement with "per segment" capacitors C or the Figure 16 circuitry with "global" capacitors C.

As mentioned above, possible methods of calibrating the shared tap points TP1 and TP2 are envisaged. For example, to calibrate the shared tap points TP1 and TP2 during evaluation of fabricated current-switching circuitry (i.e. at the design stage), an external sweeping signal could be applied to the output nodes ON1 and ON2 to overdrive those output nodes (with the switching states of the segments set so that the output signal of the current switching circuitry is at mid-scale). Then, the voltage change at the input nodes CN1/CN2 of current conveying circuitry 28 under consideration could be measured as the voltage at the output nodes ON1/ON2 changes. This measured voltage change at nodes CN1/CN2 will be zero if the shared tap points TP1/TP2 are set correctly, and they can thus be adjusted (by varying the ratio R1:R2) accordingly. In order to carry out this calibration technique without overloading the segments, it may be advisable to provide a dummy current conveyor circuit 28 for this calibration.

Such calibration could also be performed on-chip (i.e. as per-chip calibration) by switching the segments to cause the output signal at the output nodes ON1/ON2 to pass through full-scale, and by measuring again the voltage change at the input nodes CN1/CN2 of the current conveying circuitry 28. Again, this measured voltage change will be zero if the shared tap points are set correctly, and they can be adjusted accordingly. Again, it may be preferable to provide a dummy current conveyor circuit 28 for this calibration.

It will be appreciated that current switching circuitry embodying the present invention could be, or be part of, a DAC, or a programmable current generator. It will be appreciated that such circuitry could be implemented using CMOS technology, for example as, or as part of, a small-geometry CMOS chip. Such a DAC could form part of, for example, an RF transmitter. Such a DAC could be configured to operate at a sample rate substantially in the range of 5 to 20GSa/s, for example substantially at 12GSa/s.

EP 2 023 489 B1

**Claims**

1. Current switching circuitry comprising:

   first and second connection nodes (CN1, CN2) through which first and second controllable currents pass respectively when the circuitry is in use;
   switching means (S1, S2) for changing the respective magnitudes of the first and second controllable currents in dependence upon a switching signal; and
   current conveyor means (28) connected between the first and second connection nodes and first and second output nodes of the circuitry for conveying the first controllable current between the first connection node and the first output node and for conveying the second controllable current between the second connection node and the second output node,
   **characterised in that**:

   the current conveyor means comprises:

   first and second intermediate nodes (IN1, IN2);
   first shielding means (30) having a first shielding element (SE1) connected between the first intermediate node (IN1) and the first output node (ON1) and also having a second shielding element (SE2) connected between the second intermediate node (IN2) and the second output node (ON2); and
   second shielding means (32) having a first shielding element (SE1) connected between the first intermediate node (IN1) and the first connection node (CN1) and also having a second shielding element (SE2) connected between the second intermediate node (IN2) and the second connection node (CN2),

   wherein said first shielding means (30) is adapted to generate at the first and second intermediate nodes potentials that are substantially independent of variations in the output-node potentials but are dependent on said changes in the first and second controllable currents, and said second shielding means (32) is adapted to shield the first and second connection nodes from variations in the intermediate-node potentials that are dependent on said changes in the first and second controllable currents.

2. Circuitry as claimed in claim 1, wherein each said shielding element comprises a cascode transistor (46, 48, 50, 52).

3. Circuitry as claimed in claim 2, wherein:

   the cascode transistor of each of the first and second shielding elements in the first shielding means has first and second current-path terminals and a control terminal, the first current-path terminal being connected to the first or second output node; and
   the first shielding means has adjusting means operable to adjust a potential of the control terminal of each of the first and second shielding elements so as to compensate for variations in a potential difference between the control terminal and the second current-path terminal of the element concerned arising from variations in a potential difference between the first and second current-path terminals of the element concerned.

4. Circuitry as claimed in claim 2 or 3, wherein:

   the cascode transistor of each of the first and second shielding elements in the second shielding means has first and second current-path terminals and a control terminal, the first current-path terminal being connected to the first or second intermediate node; and
   the shielding means has adjusting means operable to adjust a potential of the control terminal of each of the first and second shielding elements so as to compensate for variations in potential of the second current-path terminal arising from variations in the potential of the first current-path terminal.

5. Circuitry as claimed in claim 4, wherein the adjusting means in the second shielding means is operable to adjust the control-terminal potential of each of the first and second shielding elements in dependence upon a switching state of said switching means.

6. Circuitry as claimed in claim 4 or 5, wherein the adjusting means comprises a cross-coupling connection arrangement in which the control terminal of each of the first and second shielding elements is coupled operatively to the other shielding element.

7. Circuitry as claimed in claim 6, wherein the cross-coupling arrangement couples the control terminal of each of the first and second shielding elements to the first current-path terminal of the other shielding element.

8. Circuitry as claimed in claim 7, wherein each said cascode transistor has a component of a potential difference between its said control terminal and its said second current-path terminal that varies with a current flowing between the first and second current-path terminals, and the cascode transistors are arranged such that a sum of said component for said first shielding element in said first shielding means and said component for said second shielding element in said second shielding means is substantially the same irrespective of a switching state of the switching means, and a sum of said component for said second shielding element in said first shielding means and said component for said first shielding element in said second shielding means is substantially the same irrespective of a switching state of the switching means.

9. Circuitry as claimed in claim 8, wherein each cascode transistor (50, 52) in said second shielding means is sized relative to each cascode transistor in said first shielding means such that each said sum is substantially the same irrespective of a switching state of the switching means.

10. Circuitry as claimed in claim 3, wherein the adjusting means in the first shielding means comprises:

   first resistance means (42) connected between the first output node (ON1) and a first biasing node (BN1);
   second resistance means (44) connected between the second output node (ON2) and a second biasing node (BN2);
   biasing means for maintaining each of the first and second biasing nodes at a predetermined potential when the circuitry is in use; and
   tapping means for tapping the second resistance means (44) at a tap point (TP2) to provide the control-terminal potential for the first shielding element (46) and for tapping the first resistance means (42) at a tap point (TP1) to provide the control-terminal potential for the second shielding element (48).

11. Circuitry as claimed in claim 10, wherein each said tap point (TP1, TP2) is adjustable in operation of the circuitry.

12. Circuitry as claimed in claim 10 or 11, comprising a capacitance connected between each said tap point and the output node of the resistance means concerned, the capacitances being configured to reduce voltage ripple at the connection nodes.

13. Circuitry as claimed in any preceding claim, wherein said switching means comprises at least one first switch element connected between a common node of the circuitry and said first connection node, and at least one second switch element connected between the common node and said second connection node.

14. Circuitry as claimed in claim 13, having a plurality of said first switch elements and a plurality of said second switch elements, said switching means being arranged so that at each switching event the same number of switch elements change state.

15. Segmented circuitry comprising:

   a plurality of circuitry segments, each having current switching circuitry as claimed in any preceding claim;
   first combining means, connected with the respective first output nodes of the segments and also connected operatively with a first combined signal terminal, for combining the respective first controllable currents of the segments to produce a first combined signal at the first combined signal terminal; and
   second combining means, connected with the respective second output nodes of the segments and also connected operatively with a second combined signal terminal, for combining the respective second controllable currents of the segments to produce a second combined signal at the second combined signal terminal.

16. Segmented circuitry as claimed in claim 15, wherein the first combining means comprises a first connection line interconnecting the respective first output nodes of the segments and said first combined signal terminal, and said second combining means comprise a second connection line interconnecting said respective second output nodes of the segments and the second combined signal terminal.

17. A digital-to-analogue converter comprising circuitry as claimed in any of the preceding claims.

18. An IC chip or chipset comprising circuitry as claimed in any of claims 1 to 16.

19. An RF transmitter comprising circuitry or an IC chip or chipset, or a digital-to-analogue converter, as the case may be, as claimed in any of the preceding claims.

**Patentansprüche**

1. Stromschaltanordnung mit:

   ersten und zweiten Verbindungsknoten (CN1, CN2), die erste bzw. zweite steuerbare Ströme durchlaufen, wenn die Schaltanordnung in Gebrauch ist;
   Schaltmitteln (S1, S2) zum Verändern der jeweiligen Größen der ersten und zweiten steuerbaren Ströme in Abhängigkeit von einem Schaltsignal; und
   einem Stromübertragungsmittel (28), das zwischen den ersten und zweiten Verbindungsknoten und ersten und zweiten Ausgabeknoten der Schaltanordnung verbunden ist, zum Übertragen des ersten steuerbaren Stromes zwischen dem ersten Verbindungsknoten und dem ersten Ausgabeknoten und zum Übertragen des zweiten steuerbaren Stromes zwischen dem zweiten Verbindungsknoten und dem zweiten Ausgabeknoten,
   **dadurch gekennzeichnet, dass**:

   das Stromübertragungsmittel umfasst:

   erste und zweite Zwischenknoten (IN1, IN2);
   ein erstes Schirmmittel (30), das ein erstes Schirmelement (SE1) hat, das zwischen dem ersten Zwischenknoten (IN1) und dem ersten Ausgabeknoten (ON1) verbunden ist, und auch ein zweites Schirmelement (SE2) hat, das zwischen dem zweiten Zwischenknoten (IN2) und dem zweiten Ausgabeknoten (ON2) verbunden ist; und
   ein zweites Schirmmittel (32), das ein erstes Schirmelement (SE1) hat, das zwischen dem ersten Zwischenknoten (IN1) und dem ersten Verbindungsknoten (CN1) verbunden ist, und auch ein zweites Schirmelement (SE2) hat, das zwischen dem zweiten Zwischenknoten (IN2) und dem zweiten Verbindungsknoten (CN2) verbunden ist,

   bei der das erste Schirmmittel (30) dafür ausgelegt ist, um an den ersten und zweiten Zwischenknoten Potentiale zu erzeugen, die von Schwankungen der Potentiale der Ausgabeknoten im Wesentlichen unabhängig sind, aber von den Veränderungen der ersten und zweiten steuerbaren Ströme abhängig sind, und das zweite Schirmmittel (32) dafür ausgelegt ist, um die ersten und zweiten Verbindungsknoten vor Schwankungen der Potentiale der Zwischenknoten abzuschirmen, die von den Veränderungen der ersten und zweiten steuerbaren Ströme abhängig sind.

2. Schaltanordnung nach Anspruch 1, bei der jedes Schirmelement einen Kaskodentransistor (46, 48, 50, 52) umfasst.

3. Schaltanordnung nach Anspruch 2, bei der:

   der Kaskodentransistor von jedem der ersten und zweiten Schirmelemente in dem ersten Schirmmittel erste und zweite Stromweganschlüsse und einen Steueranschluss hat, wobei der erste Stromweganschluss mit dem ersten oder zweiten Ausgabeknoten verbunden ist; und
   das erste Schirmmittel ein Einstellmittel hat, das betriebsfähig ist, um ein Potential des Steueranschlusses von jedem der ersten und zweiten Schirmelemente so einzustellen,
   um Schwankungen einer Potentialdifferenz zwischen dem Steueranschluss und dem zweiten Stromweganschluss des betreffenden Elementes zu kompensieren, die sich aus Schwankungen einer Potentialdifferenz zwischen den ersten und zweiten Stromweganschlüssen des betreffenden Elementes ergeben.

4. Schaltanordnung nach Anspruch 2 oder 3, bei der:

   der Kaskodentransistor von jedem der ersten und zweiten Schirmelemente in dem zweiten Schirmmittel erste und zweite stromweganschlüsse und einen Steueranschluss hat, wobei der erste Stromweganschluss mit dem ersten oder zweiten Zwischenknoten verbunden ist; und
   das Schirmmittel ein Einstellmittel hat, das betriebsfähig ist, um ein Potential des Steueranschlusses von jedem der ersten und zweiten Schirmelemente so einzustellen, um Schwankungen des Potentials des zweiten Stromweganschlusses zu kompensieren, die sich aus Schwankungen des Potentials des ersten Stromweganschlusses ergeben.

5. Schaltanordnung nach Anspruch 4, bei der das Einstellmittel in dem zweiten Schirmmittel betriebsfähig ist, um das Stcucranschlusspotcntial von jedem der ersten und zweiten Schirmelemente in Abhängigkeit von einem Schaltzustand der Schaltmittel einzustellen.

6. Schaltanordnung nach Anspruch 4 oder 5, bei der das Einstellmittel eine Kreuzkopplungsverbindungsanordnung umfasst, in der der Steueranschluss von jedem der ersten und zweiten Schirmelemente operativ mit dem anderen Schirmelement gekoppelt ist.

7. Schaltanordnung nach Anspruch 6, bei der die Kreuzkopplungsanordnung den Steueranschluss von jedem der ersten und zweiten Schirmelemente mit dem ersten Stromweganschluss des anderen Schirmelementes koppelt.

8. Schaltanordnung nach Anspruch 7, bei der jeder Kaskodentransistor eine Komponente einer Potentialdifferenz zwischen seinem Steueranschluss und seinem zweiten Stromweganschluss hat, die mit einem Strom schwankt, der zwischen den ersten und zweiten Stromweganschlüssen fließt, und die Kaskodentransistoren so angeordnet sind, dass eine Summe der Komponente für das erste Schirmelement in dem ersten Schirmmittel und der Komponente für das zweite Schirmelement in dem zweiten Schirmmittel ungeachtet eines Schaltzustandes der Schaltmittel im Wesentlichen dieselbe ist und eine Summe der Komponente für das zweite Schirmelement in dem ersten Schirmmittel und der Komponente für das erste Schirmelement in dem zweiten Schirmmittel ungeachtet eines Schaltzustandes der Schaltmittel im Wesentlichen dieselbe ist.

9. Schaltanordnung nach Anspruch 8, bei der jeder Kaskodentransistor (50, 52) in dem zweiten Schirmmittel bezüglich jedes Kaskodentransistors in dem ersten Schirmmittel so bemessen ist, dass jede genannte Summe ungeachtet eines Schaltzustandes der Schaltmittel im Wesentlichen dieselbe ist.

10. Schaltanordnung nach Anspruch 3, bei der das Einstellmittel in dem ersten Schirmmittel umfasst:

    ein erstes Widerstandsmittel (42), das zwischen dem ersten Ausgabeknoten (ON1) und einem ersten Vorspannungsknoten (BN1) verbunden ist;
    ein zweites Widerstandsmittel (44), das zwischen dem zweiten Ausgaheknoten (ON2) und einem zweiten Vorspannungsknoten (BN2) verbunden ist;
    ein Vorspannungsmittel zum Halten eines jeden der ersten und zweiten Vorspannungsknoten auf einem vorbestimmten Potential, wenn die Schaltanordnung in Gebrauch ist; und ein Abgreifmittel zum Abgreifen des zweiten Widerstandsmittels (44) an einem Abgreifpunkt (TP2), um das Steueranschlusspotential für das erste Schirmelement (46) zu liefern, und zum Abgreifen des ersten Widerstandsmittels (42) an einem Abgreifpunkt (TP1), um das Steueranschlusspotential für das zweite Schirmelement (48) zu liefern.

11. Schaltanordnung nach Anspruch 10, bei der jeder Abgreifpunkt (TP1, TP2) bei Betrieb der Schaltanordnung einstellbar ist.

12. Schaltanordnung nach Anspruch 10 oder 11, mit einer Kapazität, die zwischen jedem Abgreifpunkt und dem Ausgabeknoten des betreffenden Widerstandsmittels verbunden ist, welche Kapazitäten konfiguriert sind, um eine Spannungswelligkeit an den Verbindungsknoten zu reduzieren.

13. Schaltanordnung nach einem vorhergehenden Anspruch, bei der die Schaltmittel wenigstens ein erstes Schaltelement umfassen, das zwischen einem gemeinsamen Knoten der Schaltanordnung und dem ersten Verbindungsknoten verbunden ist, und wenigstens ein zweites Schaltelement, das zwischen dem gemeinsamen Knoten und dem zweiten Verbindungsknoten verbunden ist.

14. Schaltanordnung nach Anspruch 13, die eine Vielzahl der ersten Schaltelemente und eine Vielzahl der zweiten Schaltelemente hat, wobei die Schaltmittel so angeordnet sind, dass bei jedem Schaltereignis dieselbe Anzahl von Schaltelementen den Zustand verändert.

15. Segmentierte Schaltanordnung mit:

einer Vielzahl von Schaltanordnungssegmenten, die jeweils eine Stromschaltanordnung nach einem vorhergehenden Anspruch haben;

einem ersten Kombinierungsmittel, das mit den jeweiligen ersten Ausgabeknoten der Segmente verbunden ist und operativ auch mit einem Anschluss eines ersten kombinierten Signals verbunden ist, zum Kombinieren der jeweiligen ersten steuerbaren Ströme der Segmente, um ein erstes kombiniertes Signal an dem Anschluss des ersten kombinierten Signals zu erzeugen; und

ein zweites Kombinierungsmittel, das mit den jeweiligen zweiten Ausgabeknoten der Segmente verbunden ist und operativ auch mit einem Anschluss eines zweiten kombinierten Signals verbunden ist, zum Kombinieren der jeweiligen zweiten steuerbaren Ströme der Segmente, um ein zweites kombiniertes Signal an dem Anschluss des zweiten kombinierten Signals zu erzeugen,

16. Segmentierte Schaltanordnung nach Anspruch 15, bei der das erste Kombinierungsmittel eine erste Verbindungsleitung umfasst, die die jeweiligen ersten Ausgabeknoten der Segmente und den Anschluss des ersten kombinierten Signals miteinander verbindet, und das zweite Kombinierungsmittel eine zweite Verbindungsleitung umfasst, die die jeweiligen zweiten Ausgabeknoten der Segmente und den Anschluss des zweiten kombinierten Signals miteinander verbindet.

17. Digital-Analog-Konverter mit einer Schaltanordnung nach einem der vorhergehenden Ansprüche.

18. IC-Chip oder -Chipsatz mit einer Schaltanordnung nach einem der Ansprüche 1 bis 16.

19. RF-Sender mit einer Schaltanordnung oder einem IC-Chip oder -Chipsatz oder einem Digital-Analog-Konverter, je nachdem, nach einem der vorhergehenden Ansprüche.

**Revendications**

1. Circuit de commutation de courant comprenant :

des premier et second noeuds de connexion (CN1, CN2) à travers lesquels des premier et second courants contrôlables passent respectivement lorsque le circuit est utilisé;

des moyens de commutation (S1, S2) pour changer les ampleurs respectives des premier et seconds courants contrôlables en fonction d'un signal de commutation ; et

un moyen de transport du courant (28) connecté entre les premier et second noeuds de connexion et des premier et second noeuds de sortie du circuit pour transporter le premier courant contrôlable entre le premier noeud de connexion et le premier noeud de sortie et pour transporter le second courant contrôlable entre le second noeud de connexion et le second noeud de sortie, **caractérisé en ce que** :

le moyen de transport du courant comprend :

des premier et second noeuds intermédiaires (IN1, IN2) ;

un premier moyen de blindage (30) ayant un premier élément de blindage (SE1) connecté entre le premier noeud intermédiaire (IN1) et le premier noeud de sortie (ON1) et ayant également un second élément de blindage (SE2) connecté entre le second noeud intermédiaire (IN2) et le second noeud de sortie (ON2) ; et

un second moyen de blindage (32) ayant un premier élément de blindage (SE1) connecté entre le premier noeud intermédiaire (IN1) et le premier noeud de connexion (CN1) et ayant également un second élément de blindage (SE2) connecté entre le second noeud intermédiaire (IN2) et le second noeud de connexion (CN2),

dans lequel ledit premier moyen de blindage (30) est adapté à générer au niveau des premier et second noeuds intermédiaires des potentiels qui sont essentiellement indépendants de variations des potentiels de noeud de sortie mais sont dépendants desdits changements des premier et second courants contrôlables, et ledit second moyen de blindage (32) est adapté à blinder les premier et second noeuds de connexion de variations des potentiels de noeud intermédiaire qui sont dépendants desdits changements des premier et second courants contrôlables.

**2.** Circuit selon la revendication 1, dans lequel chaque élément de blindage comprend un transistor cascode (46, 48, 50, 52).

**3.** Circuit selon la revendication 2, dans lequel:

le transistor cascode de chaque des premier et second éléments de blindage dans le premier moyen de blindage possède des première et seconde bornes de chemin de courant et une borne de contrôle, la première borne de chemin de courant étant connectée au premier ou second noeud de sortie ; et
le premier moyen de blindage possède un moyen de réglage pouvant être opéré pour régler un potentiel de la borne de contrôle de chacun des premier et second éléments de blindage de manière à compenser pour des variations d'une différence de potentiel entre la borne de contrôle et la seconde borne de chemin de courant de l'élément concerné résultant de variations d'une différence de potentiel entre les première et seconde bornes de chemin de courant de l'élément concerné.

**4.** Circuit selon la revendication 2 ou 3, dans lequel :

le transistor cascode de chacun des premier et second éléments de blindage dans le second moyen de blindage possède des première et seconde bornes de chemin de courant et une borne de contrôle, la première borne de chemin de courant étant connectée au premier ou second noeud intermédiaire ; et
le moyen de blindage possède un moyen de réglage pouvant être opéré pour régler un potentiel de la borne de contrôle de chacun des premier et second éléments de blindage de manière à compenser pour des variations d'une différence de potentiel de la seconde borne de chemin de courant résultant de variations du potentiel de la première borne de chemin de courant.

**5.** Circuit selon la revendication 4, dans lequel le moyen de réglage dans le second moyen de blindage peut être opéré pour régler le potentiel de la borne de contrôle de chacun des premier et second éléments de blindage en fonction d'un état de commutation dudit moyen de commutation.

**6.** Circuit selon la revendication 4 ou 5, dans lequel le moyen de réglage comprend un agencement de connexion à couplage mutuel dans lequel la borne de contrôle de chacun des premier et second éléments de blindage est couplée de manière opérationnelle à l'autre élément de blindage.

**7.** Circuit selon la revendication 6, dans lequel l'agencement à couplage mutuel couple la borne de contrôle de chacun des premier et second éléments de blindage à la première borne de chemin de courant de l'autre élément de blindage.

**8.** Circuit selon la revendication 7, dans lequel chaque dit transistor cascode possède une composante d'une différence de potentiel entre sa dite borne de contrôle et sa dite seconde borne de chemin de courant qui varie avec un courant s'écoulant entre les première et seconde bornes de chemin de courant, et les transistors cascode sont agencés de sorte qu'une somme de ladite composante pour ledit premier élément de blindage dans ledit premier moyen de blindage et ladite composante pour ledit second élément de blindage dans ledit second moyen de blindage est essentiellement la même quel que soit un état de commutation du moyen de commutation, et une somme de ladite composante pour ledit second élément de blindage dans ledit premier moyen de blindage et ladite composante pour ledit premier élément de blindage dans ledit second moyen de blindage est essentiellement la même quel que soit un état de commutation du moyen de commutation.

**9.** Circuit selon la revendication 8, dans lequel chaque transistor cascode (50, 52) dans ledit seconde moyen de blindage est dimensionné par rapport à chaque transistor cascode dans ledit premier moyen de blindage de sorte que chaque dite somme est essentiellement la même quel que soit un état de commutation du moyen de commutation.

**10.** Circuit selon la revendication 3, dans lequel le moyen de réglage dans le premier moyen de blindage comprend :

un premier moyen de résistance (42) connecté entre le premier noeud de sortie (ON1) et un premier noeud de polarisation (BN1) ;
un second moyen de résistance (44) connecté entre le second noeud de sortie (ON2) et un second noeud de polarisation (BN2) ;
un moyen de polarisation pour maintenir chacun des premier et second noeuds de polarisation à un potentiel, prédéterminé lorsque le circuit est utilisé; et
un moyen de prise pour brancher le second moyen de résistance (44) au niveau d'un point de prise (TP2) afin de fournir le potentiel de borne de contrôle pour le premier élément de blindage (46) et pour brancher le premier moyen de résistance (42) au niveau d'un point de prise (TP1) afin de fournir le potentiel de borne de contrôle pour le second élément de blindage (48).

11. Circuit selon la revendication 10, dans lequel chaque dit point de prise (TP1, TP2) est réglable en cours de fonctionnement du circuit.

12. Circuit selon la revendication 10 ou 11, comprenant une capacité connectée entre chaque dit point de prise et le noeud de sortie du moyen de résistance concerné, les capacités étant configurées pour réduire une fluctuation de tension au niveau des noeuds de connexion.

13. Circuit selon l'une quelconque des revendications précédentes, dans lequel ledit moyen de commutation comprend au moins un premier élément de commutation connecté entre un noeud commun du circuit et ledit premier noeud de connexion, et au moins un second élément de commutation connecté entre le noeud commun et ledit second noeud de connexion.

14. Circuit selon la revendication 13, ayant une pluralité desdits premiers éléments de commutation et une pluralité desdits seconds éléments de commutation, ledit moyen de commutation étant agencé de sorte qu'à chaque événement de commutation, le même nombre d'éléments de commutation changent d'état.

15. Circuit segmenté comprenant :

une pluralité de segments de circuit, ayant chacun un circuit de commutation de courant selon l'une quelconque des revendications précédentes ;
un premier moyen de combinaison connecté aux premiers noeuds de sortie respectifs des segments et également connecté de manière opérationnelle à une première borne de signal combinée, pour combiner les premiers courants contrôlables respectifs des segments afin de produire un premier signal combiné au niveau de la première borne de signal combinée ; et
un second moyen de combinaison connecté aux seconds noeuds de sortie respectifs des segments et également connecté de manière opérationnelle à une seconde borne de signal combinée, pour combiner les seconds courants contrôlables respectifs des segments afin de produire un second signal combiné au niveau de la seconde borne de signal combinée.

16. Circuit segmenté selon la revendication 15, dans lequel le premier moyen de combinaison comprend une première ligne de connexion interconnectant les premiers noeuds de sortie respectifs des segments et ladite première borne de signal combinée, et ledit second moyen de combinaison comprend une seconde ligne de connexion interconnectant lesdits seconds noeuds de sortie respectifs des segments et la seconde borne de signal combinée.

17. Convertisseur numérique-analogique comprenant un circuit selon l'une quelconque des revendications précédentes.

18. Puce ou jeu de puces de circuit intégré comprenant un circuit selon l'une quelconque des revendications 1 à 16.

19. Transmetteur de radiofréquence comprenant un circuit ou une puce ou un jeu de puces de circuit intégré, ou un convertisseur numérique-analogique, selon le cas, selon l'une quelconque des revendications précédentes.

FIG. 1

FIG. 2

FIG. 3

EP 2 023 489 B1

FIG. 4

EP 2 023 489 B1

ANALOG VDD

SEG$_1$ ··· SEG$_{i-1}$

18  I$_{BLEED}$

14  I  SEG$_i$

SW1 —[ P $\diagup$ S1   S2 $\diagdown$ P ]— SW2

ON1   ←ΔV$_{INT}$→   ON2

SEG$_{i+1}$ ··· SEG$_n$

20  I$_{BLEED}$

A

I$_A$

P  322

R1

⊠ V$_A$

OUTA

B

I$_B$

I$_{DA}$

330

D1~Dm   DUMMY DAC

DON1

DON2   I$_{DB}$

P

⊠ V$_B$

OUTB

R2

FIG. 5

FIG. 6

ON1                                    ON2

28

34

| SE1 | ADJUSTMENT SECTION | SE2 |

30

FIRST SHIELDING CIRCUIT

IN1                                    IN2

36

| SE1 | ADJUSTMENT SECTION | SE2 |

32

SECOND SHIELDING CIRCUIT

$I_{BIG}\,(I_{SMALL})$                    $I_{SMALL}\,(I_{BIG})$

CN1                                    CN2

FIG. 7

FIG. 8

FIG. 9

FIG. 10

EP 2 023 489 B1

FIG. 11

FIG. 12

FIG. 13

FIG. 14

FIG. 15

FIG. 16

**EP 2 023 489 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2356302 A
- US 20020030619 A1
- EP 1292035 A